# EUROPEAN PATENT APPLICATION

(11) **EP 4 842 187 A1**
(43) Date of publication of application: **18.11.2026**
(21) Application number: 26164593.1
(22) Date of filing: 13.03.2026
(51) Int. Cl.: H10P 72/30, H10P 72/00

(54) **SUBSTRATE PROCESSING APPARATUS**

(30) Priority: 18.03.2025 JP 2025044098
(71) Applicant: SCREEN Holdings Co., Ltd., Kyoto-shi, Kyoto 602-8585 (JP)
(72) Inventor: ISEKI, Keita, Kyoto, 602-8585 (JP); YASHIKI, Hiroyuki, Kyoto, 602-8585 (JP); NISHIDE, Hajime, Kyoto, 602-8585 (JP); TERAI, Ken, Kyoto, 602-8585 (JP)
(74) Representative: Kilian Kilian & Partner mbB

(57) **Abstract**

A substrate processing apparatus of the present invention includes: a first processing unit (11) that performs first processing on a substrate; a second processing unit (21) that is provided adjacent to the first processing unit (11) in a horizontal direction and performs second processing different from the first processing on the substrate; a partition wall (34) that is provided between the first processing unit (11) and the second processing unit (21) and includes a passage port that allows the substrate to pass through; and an auxiliary robot (12) that conveys the substrate between the first processing unit (11) and the second processing unit (21) via the passage port, and the auxiliary robot (12) is provided at a position separated from a virtual straight line connecting the first processing unit (11) and the second processing unit (21).

## Description

### Background of the invention

The present invention relates to a substrate processing apparatus that performs predetermined processing on various substrates such as a semiconductor substrate, a substrate for a flat panel display (FPD) such as a liquid crystal display or an organic electroluminescence (EL) display substrate, a glass substrate for a photomask, and a substrate for an optical disk.

### Description of the Related Art

A substrate processing apparatus of JP 2001-7065 A includes an etching processing chamber and a cleaning and drying processing chamber. The second conveyance chamber is interposed between the etching processing chamber and the cleaning and drying processing chamber. The substrate on which etching processing has been completed is conveyed from the etching chamber to the cleaning and drying chamber by a conveyance robot in the second conveyance chamber. Thereafter, the substrate is subjected to cleaning and drying processing in the cleaning and drying processing chamber.

### <List of documents>

JP 2001-7065

However, the conventional substrate processing apparatus has been insufficiently studied from the viewpoint of reducing the footprint.

### Summary of the invention

The present invention has been made in view of such circumstances, and an object of the present invention is to provide a compact substrate processing apparatus having a reduced footprint in the substrate processing apparatus including a first processing chamber, a second processing chamber, and a conveyance robot that conveys a substrate between the first processing chamber and the second processing chamber.

In order to solve the above-described problems, the present invention has the following configuration.

A substrate processing apparatus according to the present invention is a substrate processing apparatus including a substrate processing chamber configured to process a substrate in a horizontal attitude, the substrate processing apparatus including
a center robot configured to transfer the substrate to and from the substrate processing chamber,
in which the substrate processing chamber includes:
   a first processing unit configured to perform first processing on the substrate;
   a second processing unit provided adjacent to the first processing unit in a horizontal direction and configured to perform second processing different from the first processing on the substrate;
   a partition wall provided between the first processing unit and the second processing unit and including a passage port configured to allow the substrate to pass through; and
   an auxiliary robot configured to convey the substrate between the first processing unit and the second processing unit via the passage port,
   the auxiliary robot includes:
      a robot base provided adjacent to the partition wall;
      a substrate conveyance arm configured to be movably supported by the robot base;
      a hand configured to be supported by the substrate conveyance arm and hold the substrate;
      an arm turning mechanism configured to turn the substrate conveyance arm with reference to the robot base;
      an arm length adjustment mechanism configured to change a turning radius of the hand by changing an arm length of the substrate conveyance arm; and
      a control unit configured to control the arm turning mechanism and the arm length adjustment mechanism, and
   the auxiliary robot is provided at a position separated from a virtual straight line connecting the first processing unit and the second processing unit.

[Operation and Effect] The substrate processing apparatus of the present invention includes: the first processing unit that performs the first processing on the substrate; the second processing unit that is provided adjacent to the first processing unit in a horizontal direction and performs the second processing different from the first processing on the substrate; the partition wall that is provided between the first processing unit and the second processing unit and includes the passage port that allows the substrate to pass through; and the auxiliary robot that conveys the substrate between the first processing unit and the second processing unit via the passage port, and the auxiliary robot is provided at a position separated from a virtual straight line connecting the first processing unit and the second processing unit. With this configuration, since the first processing unit, the auxiliary robot, and the second processing unit can be arranged in a zigzag manner, a distance between the first processing unit and the second processing unit can be shortened as compared with the conventional configuration. Therefore, according to the present invention, a substrate processing apparatus having a small footprint can be provided.

Furthermore, in the substrate processing apparatus described above, it is preferable that the auxiliary robot is provided on a side opposite to the center robot across the virtual straight line connecting the first processing unit and the second processing unit.

[Operation and Effect] The auxiliary robot of the substrate processing apparatus described above is provided on the side opposite to the center robot across the virtual straight line connecting the first processing unit and the second processing unit. With this configuration, the auxiliary robot does not hinder the substrate conveyance of the center robot.

Furthermore, in the substrate processing apparatus described above, it is preferable that a distance between the first processing unit and the robot base is shorter than a distance between the second processing unit and the robot base.

[Operation and Effect] In the substrate processing apparatus described above, the distance between the first processing unit and the robot base is shorter than the distance between the second processing unit and the robot base. According to such a configuration, the auxiliary robot can be provided close to the first processing unit. With this configuration, the second processing unit that is located downstream of the substrate processing and performs finishing in the substrate processing, and the auxiliary robot that causes generation of particles can be separated as much as possible.

Furthermore, in the substrate processing apparatus described above, it is preferable that the hand in the auxiliary robot is located above the substrate when holding the substrate.

[Operation and Effect] The hand in the auxiliary robot of the substrate processing apparatus described above is located above the substrate when holding the substrate. With this configuration, since the configuration of the processing unit can be diversified, it is possible to provide the substrate processing apparatus capable of coping with various substrate processing.

Furthermore, in the substrate processing apparatus described above, it is preferable that the substrate conveyance arm is extendable and contractible.

[Operation and Effect] The substrate conveyance arm of the substrate processing apparatus described above is extendable and contractible. Therefore, the substrate conveyance arm can reliably adjust the arm length.

Furthermore, in the substrate processing apparatus described above, it is preferable that the substrate conveyance arm includes a plurality of joints.

[Operation and Effect] The substrate conveyance arm of the substrate processing apparatus described above includes the plurality of joints. Therefore, the substrate conveyance arm can reliably adjust the arm length.

Furthermore, in the substrate processing apparatus described above, it is preferable that the control unit controls the arm turning mechanism and the arm length adjustment mechanism to linearly move the substrate from the first processing unit to the second processing unit.

[Operation and Effect] The control unit of the substrate processing apparatus described above controls the arm turning mechanism and the arm length adjustment mechanism to linearly move the substrate from the first processing unit to the second processing unit. With this configuration, since a conveyance distance of the substrate becomes the shortest, the substrate conveyance becomes fast.

Furthermore, in the substrate processing apparatus described above, it is preferable that
the control unit
controls the arm length adjustment mechanism to bring the substrate acquired by the first processing unit close to the robot base,
controls the arm turning mechanism to turn the substrate with reference to the robot base, and
controls the arm length adjustment mechanism to displace the substrate away from the robot base and convey the substrate to the second processing unit.

[Operation and Effect] The control unit of the substrate processing apparatus described above controls the arm length adjustment mechanism to bring the substrate acquired by the first processing unit close to the robot base, controls the arm turning mechanism to turn the substrate with reference to the robot base, and controls the arm length adjustment mechanism to displace the substrate away from the robot base and convey the substrate to the second processing unit. With this configuration, since a turning radius when the substrate is turned can be minimized, it is possible to reliably convey the liquid-filled substrate in particular.

According to the present invention, it is possible to provide a compact substrate processing apparatus with a reduced footprint.

### Brief description of the drawings

FIG. 1 is a plan view for explaining an overall configuration of a substrate processing apparatus according to an embodiment;
FIG. 2 is a plan view for explaining a substrate processing chamber according to the embodiment;
FIG. 3 is a cross-sectional view for explaining a configuration of a first processing chamber according to the embodiment;
FIG. 4 is a cross-sectional view for explaining a configuration of a second processing chamber according to the embodiment;
FIG. 5 is a plan view for explaining the configuration of an auxiliary robot according to the embodiment;
FIG. 6 is a plan view for explaining the configuration of the auxiliary robot according to the embodiment;
FIG. 7 is a plan view for explaining the configuration of the auxiliary robot according to the embodiment;
FIG. 8 is a plan view for explaining the configuration of the auxiliary robot according to the embodiment;
FIG. 9 is a plan view for explaining the configuration of the auxiliary robot according to the embodiment;
FIG. 10 is a plan view for explaining an operation of the auxiliary robot according to the embodiment;
FIG. 11 is a plan view for explaining the operation of the auxiliary robot according to the embodiment;
FIG. 12 is a plan view for explaining the operation of the auxiliary robot according to the embodiment;
FIG. 13 is a plan view for explaining a configuration of a hand of the auxiliary robot according to the embodiment;
FIG. 14 is a perspective view for explaining a vertical movement mechanism of the auxiliary robot according to the embodiment;
FIG. 15 is a plan view for explaining a configuration of a lower hand of a center robot according to the embodiment;
FIG. 16 is a side view for explaining a stacked state of the substrate processing chamber according to the embodiment;
FIG. 17 is a flowchart for explaining a flow of a substrate according to the embodiment;
FIG. 18 is a cross-sectional view for explaining the flow of the substrate according to the embodiment;
FIG. 19 is a cross-sectional view for explaining the flow of the substrate according to the embodiment;
FIG. 20 is a cross-sectional view for explaining the flow of the substrate according to the embodiment;
FIG. 21 is a cross-sectional view for explaining the flow of the substrate according to the embodiment;
FIG. 22 is a cross-sectional view for explaining the flow of the substrate according to the embodiment;
FIG. 23 is a cross-sectional view for explaining the flow of the substrate according to the embodiment;
FIG. 24 is a cross-sectional view for explaining the flow of the substrate according to the embodiment;
FIG. 25 is a cross-sectional view for explaining the flow of the substrate according to the embodiment;
FIG. 26 is a cross-sectional view for explaining the flow of the substrate according to the embodiment;
FIG. 27 is a cross-sectional view for explaining the flow of the substrate according to the embodiment;
FIG. 28 is a cross-sectional view for explaining the flow of the substrate according to the embodiment;
FIG. 29 is a cross-sectional view for explaining the flow of the substrate according to the embodiment;
FIG. 30 is a cross-sectional view for explaining the flow of the substrate according to the embodiment;
FIG. 31 is a cross-sectional view for explaining the flow of the substrate according to the embodiment;
FIG. 32 is a cross-sectional view for explaining the flow of the substrate according to the embodiment;
FIG. 33 is a cross-sectional view for explaining the flow of the substrate according to the embodiment;
FIG. 34 is a cross-sectional view for explaining the flow of the substrate according to the embodiment;
FIG. 35 is a perspective view for explaining a configuration of a support member according to the embodiment;
FIG. 36 is a perspective view for explaining the configuration of the support member according to the embodiment;
FIG. 37 is a flowchart for explaining a substrate acquisition operation according to the embodiment;
FIG. 38 is a flowchart for explaining a substrate placement operation according to the embodiment;
FIG. 39 is a cross-sectional view for explaining the substrate acquisition operation according to the embodiment;
FIG. 40 is a cross-sectional view for explaining the substrate acquisition operation according to the embodiment;
FIG. 41 is a cross-sectional view for explaining the substrate acquisition operation according to the embodiment;
FIG. 42 is a cross-sectional view for explaining the substrate acquisition operation according to the embodiment;
FIG. 43 is a cross-sectional view for explaining the substrate acquisition operation according to the embodiment;
FIG. 44 is a cross-sectional view for explaining the substrate acquisition operation according to the embodiment;
FIG. 45 is a cross-sectional view for explaining the substrate acquisition operation according to the embodiment;
FIG. 46 is a cross-sectional view for explaining the substrate placement operation according to the embodiment;
FIG. 47 is a cross-sectional view for explaining the substrate placement operation according to the embodiment;
FIG. 48 is a cross-sectional view for explaining the substrate placement operation according to the embodiment;
FIG. 49 is a cross-sectional view for explaining the substrate placement operation according to the embodiment;
FIG. 50 is a cross-sectional view for explaining the substrate placement operation according to the embodiment;
FIG. 51 is a cross-sectional view for explaining the substrate placement operation according to the embodiment;
FIG. 52 is a cross-sectional view for explaining the substrate placement operation according to the embodiment;
FIG. 53 is a side view for explaining an intake and exhaust pipe according to the embodiment;
FIG. 54 is a perspective view for explaining a branch pipe according to the embodiment;
FIG. 55 is a perspective view for explaining a rectifying system according to the embodiment;
FIG. 56 is a cross-sectional view for explaining an air flow generated by the rectifying system according to the embodiment;
FIG. 57 is a perspective view for explaining the air flow generated by the rectifying system according to the embodiment;
FIG. 58 is a cross-sectional view for explaining the air flow generated by the rectifying system according to the embodiment;
FIG. 59 is a cross-sectional view for explaining the air flow generated by the rectifying system according to the embodiment;
FIG. 60 is a perspective view for explaining the air flow generated by the rectifying system according to the embodiment;
FIG. 61 is a schematic diagram for explaining an operation of the rectifying system according to the embodiment;
FIG. 62 is a flowchart for explaining an exhaust method of the embodiment;
FIG. 63 is a plan view for explaining one modification of the present invention;
FIG. 64 is a plan view for explaining one modification of the present invention;
FIG. 65 is a plan view for explaining one modification of the present invention;
FIG. 66 is a plan view for explaining one modification of the present invention; and
FIG. 67 is a plan view for explaining one modification of the present invention.

### Description of the preferred embodiments

Hereinafter, an embodiment of the present invention will be described with reference to the drawings. A substrate processing apparatus according to the present invention is configured to process a substrate in a horizontal attitude. The substrate processing apparatus includes a first processing chamber and a second processing chamber formed by partitioning a housing of a substrate processing chamber with a partition wall. In the first processing chamber, the first processing is performed. The substrate on which the first processing has been completed is subjected to the second processing. By dividing substrate processing between the first processing chamber and the second processing chamber, it is possible to change a mechanism for the substrate processing between the first processing chamber and the second processing chamber. The substrate processing apparatus of the present invention can perform various substrate processing as compared with a normal substrate processing apparatus. Embodiment

### <1. Overall Configuration>

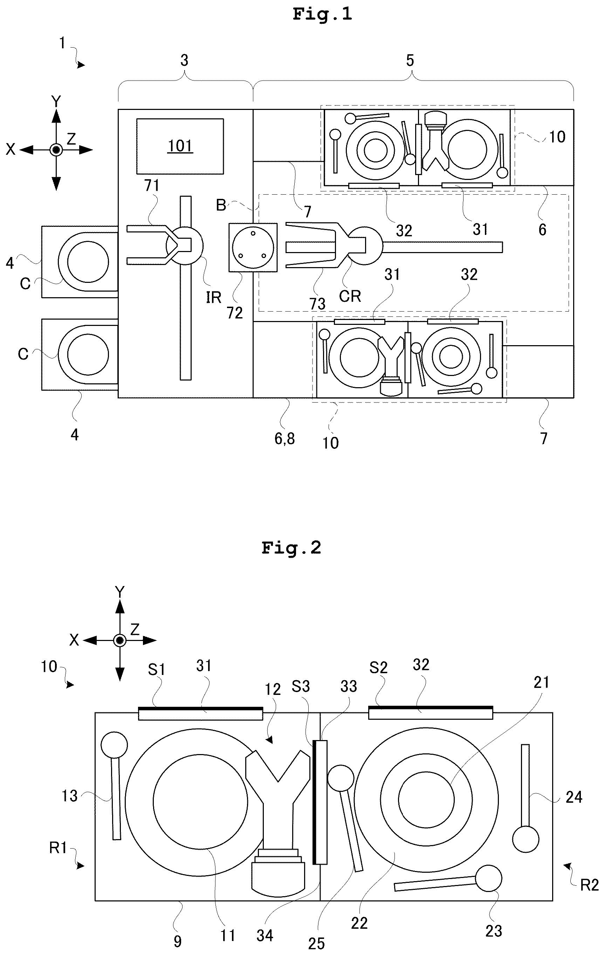

The overall configuration of a substrate processing apparatus 1 will be described with reference to FIGS. 1 and 2. FIG. 1 is a plan view for explaining an overall configuration of the substrate processing apparatus according to the present embodiment. FIG. 2 is a plan view for explaining a substrate processing chamber according to the present embodiment. As illustrated in FIG. 1, the substrate processing apparatus 1 of the present embodiment is divided into a plurality of blocks. The substrate processing apparatus 1 of the present embodiment includes an indexer block 3 and a substrate processing block 5. The indexer block 3 and the substrate processing block 5 are arranged in an X direction (front-rear direction). The X direction corresponds to a horizontal direction of the present invention.

In the present embodiment, a Z direction is a vertical direction, and a Y direction is a horizontal direction orthogonal to the X direction and the Z direction.

The indexer block 3 includes a load port 4 on which a carrier C that stores a plurality of substrates W in a horizontal attitude at predetermined intervals in the vertical direction is placed. The load port 4 protrudes from an outer wall of the indexer block 3 extending in the width direction (Y direction). When the carrier C storing the unprocessed substrate W is placed on the load port 4, the substrate processing apparatus 1 takes out the substrate W from the carrier C and takes the substrate W into the apparatus. An empty carrier C remains in the load port 4. When the substrate processing apparatus 1 performs predetermined processing on the substrate W, the substrate processing apparatus 1 returns the processed substrate W to the empty carrier C placed on the load port 4. In this way, the substrate W stored in the carrier C is returned to the original carrier C after predetermined processing is performed by the substrate processing apparatus 1.

The load ports 4 are arranged in the Y direction on the outer wall of the indexer block 3. Therefore, the substrate processing apparatus 1 of the present embodiment can place a plurality of the carriers C on the load port 4 at a time.

The carrier C is a container that stores the substrates W arranged in the vertical direction and in a horizontal attitude. Examples of the carrier C include a sealed front opening unify pod (FOUP). In the present invention, an open type container may be employed as the carrier C. The carrier C can store, for example, 25 substrates arranged at a full pitch (1 cm interval).

The indexer block 3 includes an indexer robot IR therein. The indexer robot IR includes a collective hand 71 that collectively receives the 25 substrates W stored in the carrier C. The indexer robot IR can rotate the collective hand 71 about the Z axis. Therefore, the indexer robot IR can direct the collective hand 71 toward the load port 4 or the substrate processing block 5.

In addition, the indexer robot IR is movable in the Y direction. With this configuration, the indexer robot IR can access any of the plurality of load ports 4 arranged in the Y direction.

Between the indexer block 3 and the substrate processing block 5, a path 72 for transferring the substrate W between the blocks is provided. The path 72 is a temporary placement place of the substrate W on which a plurality of substrates W can be stacked and placed in the Z direction. The indexer robot IR places the substrate W acquired by the collective hand 71 on the path 72. In this manner, the 25 substrates W are stacked and placed on the path 72.

The substrate processing block 5 includes a center robot CR movable in the X direction. The center robot CR can convey the substrates W in a horizontal attitude one by one from the above-described path 72. The center robot CR is housed in a region B extending in the X direction. The path 72 is disposed in front of the region B. The center robot CR transfers the substrate to and from the substrate processing chamber 10. The center robot CR includes a hand 73 that supports the substrate W, and the hand 73 approaches from below the substrate W when supporting the substrate W. The hand 73 corresponds to a lower hand of the present invention. The center robot CR is provided adjacent to the substrate processing chamber 10.

The substrate processing chambers 10 for applying predetermined processing to the substrates W are provided on the left and right of the region B. The center robot CR can carry the substrate W into the substrate processing chamber 10 through a first opening 31 provided in the substrate processing chamber 10. As illustrated in FIG. 2, the first opening 31 is provided in a housing 9 surrounding a first processing chamber R1, and is configured for the center robot CR to carry the substrate W into the first processing chamber R1. The first opening 31 is orthogonal to the Y direction.

Similarly, the center robot CR can carry the substrate W out of the substrate processing chamber 10 through a second opening 32 provided in the substrate processing chamber 10. The second opening 32 is provided in the housing 9 surrounding a second processing chamber R2, and is configured for the center robot CR to carry the substrate W out of the second processing chamber R2. The second opening 32 is orthogonal to the Y direction.

The first opening 31 and the second opening 32 are arranged in the X direction in the substrate processing chamber 10. Therefore, the substrate W has moved from the position of the first opening 31 to the position of the second opening 32 inside the substrate processing chamber 10. This movement is performed by an auxiliary robot provided inside the substrate processing chamber 10. The auxiliary robot will be described later.

The first opening 31 is provided with a vertically movable first shutter S1, and is displaceable between a closed state of closing the first opening 31 and an open state of opening the first opening 31. The first shutter S1 is in a closed state during the first processing to separate the first processing chamber R1 from the outside air.

Similarly, the second opening 32 is provided with a vertically movable second shutter S2, and is displaceable between a closed state in which the second opening 32 is closed and an open state in which the second opening 32 is opened. The second shutter S2 is in a closed state during the second processing to separate the second processing chamber R2 from the outside air.

Various members that support the substrate processing in the substrate processing chamber 10 are provided in front of and behind the substrate processing chamber 10. The exhaust mechanism 6 and the liquid supply mechanism 7 are provided so as to sandwich the substrate processing chamber 10 from the front and the rear. The exhaust mechanism 6 is provided for the purpose of sucking the gas inside the substrate processing chamber 10, thereby controlling the air flow inside the substrate processing chamber 10. The exhaust mechanism 6 is configured to exhaust gas from the first processing chamber R1 and the second processing chamber R2.

The liquid supply mechanism 7 is configured to supply a liquid used for substrate processing by the substrate processing chamber 10. The liquid supply mechanism 7 is provided with a pressure gauge related to liquid supply, a pump that applies pressure to the liquid, a valve that controls an ejection amount of the liquid, a heater that heats the liquid, and the like. The liquid supply mechanism 7 is configured to supply liquid to the first processing chamber R1 and the second processing chamber R2.

The exhaust mechanism 6, the first processing chamber R1, the second processing chamber R2, and the liquid supply mechanism 7 are arranged in this order in a line.

An electrical circuit 8 is provided in the vicinity of the exhaust mechanism 6. The electrical circuit 8 is configured to mainly supply power to the substrate processing chamber 10. The electrical circuit 8 is provided at a position separated from the liquid supply mechanism 7. With such a configuration, the liquid supply mechanism 7 can be reliably adjacent to the substrate processing chamber 10.

A control unit 101 includes, for example, a central processing unit (CPU). The control unit 101 is configured to perform various controls related to the indexer robot IR, the center robot CR, the exhaust mechanism 6, the liquid supply mechanism 7, the electrical circuit 8, and the substrate processing chamber 10. The control unit 101 operates by acquiring various types of information from a storage unit (not illustrated). The storage unit stores programs and parameters necessary for the operation of the control unit 101.

### <2. Substrate Processing Chamber>

FIG. 2 specifically illustrates the substrate processing chamber 10 of the present embodiment. As illustrated in FIG. 2, the substrate processing chamber 10 of the present embodiment is configured by storing various mechanisms in the housing 9. The housing 9 is a rectangular parallelepiped extending in the X direction. The housing 9 includes two wall plates orthogonal to the X direction, two wall plates orthogonal to the Y direction, and a bottom plate and a ceiling plate orthogonal to the Z direction.

A plate-shaped partition wall 34 orthogonal to the X direction is provided inside the housing 9. The partition wall 34 is configured to partition the internal space of the housing 9 into a first processing chamber R1 and a second processing chamber R2. The first processing chamber R1 is formed by partitioning a housing 9 by the partition wall 34. Similarly, the second processing chamber R2 is formed by partitioning the housing 9 by the partition wall 34. The partition wall 34 is provided with a passage port 33 for conveying the substrate in the substrate processing chamber 10. The passage port 33 is provided in the partition wall 34 and allows the substrate W to pass therethrough. The first processing chamber R1 and the second processing chamber R2 are arranged in the X direction.

The first processing chamber R1 stores the first processing unit that performs first half processing in the substrate W. Specifically, the first processing unit includes a plate 11 on which the substrate W in a horizontal attitude is placed. The substrate W placed on the plate 11 is subjected to predetermined processing (first processing). The plate 11 is a stage that does not have a mechanism for holding the substrate W or a mechanism for rotating the substrate W. A specific example of the first processing will be described later. The plate 11 is in contact with and supports the entire lower surface of the substrate W.

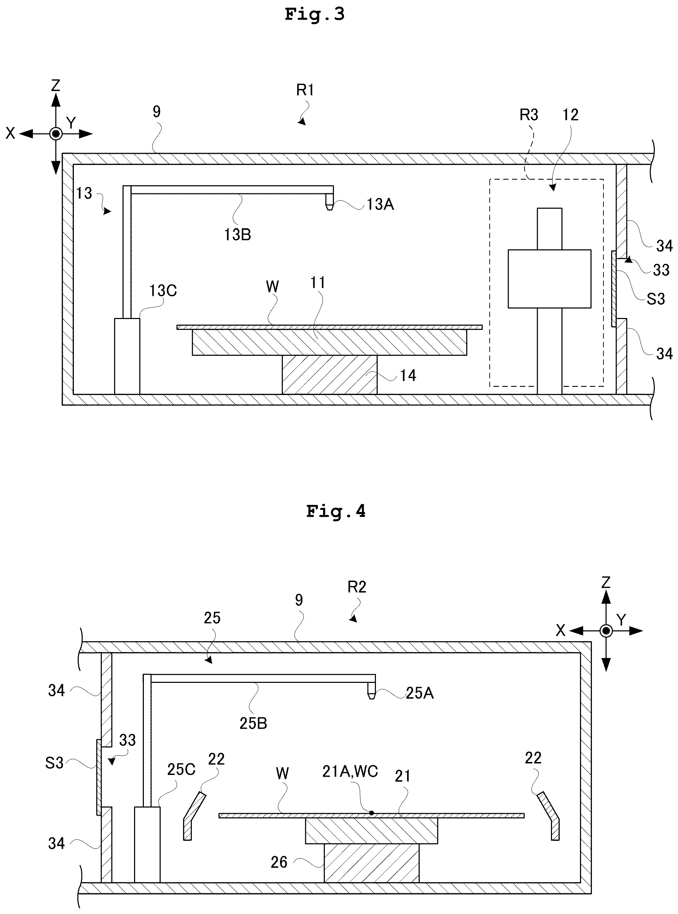

The first processing unit further includes a liquid supply nozzle 13, a support member 14 (see FIG. 3), and the like.

The second processing chamber R2 stores a second processing unit that performs second half processing on the substrate W. Specifically, the second processing unit includes a vacuum chuck 21 that holds the substrate W in a horizontal attitude. The substrate W held by the vacuum chuck 21 is subjected to a predetermined processing (second processing). A specific example of the second processing will be described later. Note that the vacuum chuck 21 has a disk shape in plan view, and the diameter of the vacuum chuck 21 is smaller than the diameter of the plate 11. The second processing is different from the first processing. The vacuum chuck 21 corresponds to a spin chuck of the present invention, and is configured to rotatably support the substrate W.

The second processing unit further includes a cup 22, a liquid supply nozzle 23, a liquid supply nozzle 24, a liquid supply nozzle 25, a motor 26, and the like.

The auxiliary robot 12 is provided in the first processing chamber R1. The auxiliary robot 12 is provided in the vicinity of the partition wall 34 in the first processing chamber R1. The auxiliary robot 12 is provided mainly for the purpose of conveying the substrate W placed on the plate 11 to the vacuum chuck 21. The auxiliary robot 12 conveys the substrate W so that the substrate W passes through the passage port 33 of the partition wall 34. A specific configuration of the auxiliary robot 12 will be described later. The auxiliary robot 12 conveys the substrate W between the first processing chamber R1 and the second processing chamber R2 via the passage port 33. More specifically, the auxiliary robot 12 conveys the substrate W from the first processing chamber R1 to the second processing chamber R2.

In addition, the substrate processing chamber 10 is provided with a liquid supply nozzle 13 for supplying liquid to the substrate W. The liquid supply nozzle 13 is provided in the first processing chamber R1, and is provided to perform liquid filling on the substrate placed on the plate 11. The liquid supply nozzle 25 is provided in the second processing chamber R2 and supplies a cleaning liquid to the upper surface of the substrate. The liquid supply nozzle 23 is provided in the second processing chamber R2 and supplies an acidic liquid to the upper surface of the substrate. The liquid supply nozzle 24 is provided in the second processing chamber R2 and supplies an alkaline liquid to the upper surface of the substrate.

### <3. First Processing Chamber>

The first processing chamber R1 of the present embodiment will be described with reference to FIG. 3. FIG. 3 is a cross-sectional view for explaining the configuration of the first processing chamber according to the present embodiment. As illustrated in FIG. 3, the first processing chamber R1 of the present embodiment is a region surrounded by the housing 9 and the partition wall 34.

The partition wall 34 is provided inside the housing 9 and has a flat plate shape orthogonal to the X direction. The partition wall 34 is provided with the passage port 33. The passage port 33 is provided with a vertically movable separation shutter S3, and the separation shutter S3 is displaceable between a closed state of closing the passage port 33 and an open state of opening the passage port 33. The separation shutter S3 is provided on the first processing chamber R1 side of the partition wall 34. The particles generated by the operation of the separation shutter S3 hardly enter the second processing chamber R2 related to substrate cleaning. The separation shutter S3 is provided in the passage port 33 and is openable and closable to separate the first processing chamber R1 and the second processing chamber R2.

The plate 11 is a stage having no function of rotating the substrate W, and has a disk shape in plan view (see FIG. 2). The plate 11 is slightly smaller than the substrate W, and causes the peripheral edge portion of the substrate to protrude outward from the peripheral edge of the plate 11 when supporting the substrate. The plate 11 has substantially the same shape as the substrate W in plan view, and the center of the plate 11 and the center of the substrate W placed on the plate 11 coincide with each other in plan view. Therefore, the plate 11 substantially contacts the entire lower surface of the substrate to support the substrate W. Since the plate 11 does not have a drive mechanism such as a pin that moves the substrate W vertically, the entire substrate W can be brought into contact under the same condition.

The plate 11 is an electrode for applying a voltage to the substrate W. Such a plate 11 is suitable for electrolytic etching of the substrate W. In order to apply a voltage to the substrate W, another electrode is required on the upper surface of the substrate. When the member is brought into contact with the upper surface of the substrate, the circuit pattern formed on the upper surface of the substrate is damaged. Therefore, a conductive processing liquid may be supplied onto the upper surface of the substrate, and a predetermined voltage may be applied between the processing liquid and the plate 11. The processing liquid is supplied onto the upper surface of the substrate by a liquid supply nozzle 13 described later. The plate 11 corresponds to a first processing unit of the present invention.

The center point 11A of the plate 11 coincides with the center point WC of the substrate W supported on the plate 11.

The liquid supply nozzle 13 is provided for the purpose of supplying a predetermined liquid to the upper surface of the substrate W. The liquid supply nozzle 13 includes a distal end portion 13A that ejects liquid, an arm 13B that supports the distal end portion 13A, and an arm turning mechanism 13C that turns the arm 13B. The arm 13B is connected such that an extending member extending in the horizontal direction and a vertical member extending in the vertical direction form an L shape, and includes a pipe for supplying liquid to the distal end portion 13A. The arm turning mechanism 13C is configured to turn the extending member by rotating the vertical member. The arm turning mechanism 13C is configured to rotate the extending member around the vertical member. The arm turning mechanism 13C can move the distal end portion 13A from a position coinciding with the center of the substrate W placed on the plate 11 in plan view to a position retracted from above the substrate W.

In addition, the first processing chamber R1 is provided with a support member 14 for supporting the plate 11. The support member 14 is sandwiched between the bottom plate of the housing 9 and the plate 11.

The first processing chamber R1 is provided with an auxiliary robot 12 that conveys a substrate. The auxiliary robot 12 is at a position sandwiched between the plate 11 (first processing unit) and the partition wall 34 in plan view. A region R3 for disposing the auxiliary robot 12 is provided inside the first processing chamber R1, and the plate 11 is provided avoiding the region R3.

### <4. Second Processing Chamber>

The second processing chamber R2 of the present embodiment will be described with reference to FIG. 4. FIG. 4 is a cross-sectional view for explaining a configuration of the second processing chamber according to the present embodiment. As illustrated in FIG. 4, the second processing chamber R2 of the present embodiment is a region surrounded by the housing 9 and the partition wall 34.

The vacuum chuck 21 is configured to suck and support the substrate W. Furthermore, the vacuum chuck 21 rotatably supports the substrate W. The vacuum chuck 21 allows the substrate W to rotate about a vertical axis passing through the center of the substrate W. The vacuum chuck 21 corresponds to a second processing unit of the present invention.

The cup 22 is a cylindrical member surrounding the substrate W, and is configured to receive a cleaning liquid shaken off from the substrate W when the substrate W rotates. As a result, the processing liquid does not scatter to the housing 9 and the partition wall 34 constituting the second processing chamber R2. The cup 22 is vertically movable. When the substrate W is transferred to and from the vacuum chuck 21, the cup 22 is in a lowered state. Therefore, the substrate W is exposed from the cup 22, and the cup 22 does not collide with the auxiliary robot 12 and the center robot CR. When the cleaning liquid is supplied to the substrate W, the cup 22 is in a rising state. Therefore, the cleaning liquid shaken off from the substrate W is reliably received in the cup 22.

The liquid supply nozzle 23, the liquid supply nozzle 24, and the liquid supply nozzle 25 have the same configurations as the liquid supply nozzle 13 of the first processing chamber R1 described above. That is, the liquid supply nozzles 23, 24, and 25 are provided for the purpose of supplying a predetermined liquid to the upper surface of the substrate W. For example, the liquid supply nozzle 25 is similar to the liquid supply nozzle 13 of the first processing chamber R1 described above in that the liquid supply nozzle 25 includes a distal end portion 25A that ejects the cleaning liquid, an arm 25B that supports the distal end portion 25A, and an arm turning mechanism 25C that turns the arm 25B (see FIG. 4). The shapes of the arms in the liquid supply nozzle 23, the liquid supply nozzle 24, and the liquid supply nozzle 25, the presence of the pipe, and the method of moving the distal end portion are also the same as those of the liquid supply nozzle 13 described above.

In addition, the second processing chamber R2 is provided with a motor 26 for rotationally driving the vacuum chuck 21. The motor 26 is sandwiched between the bottom plate of the housing 9 and the vacuum chuck 21.

### <5. Auxiliary Robot>

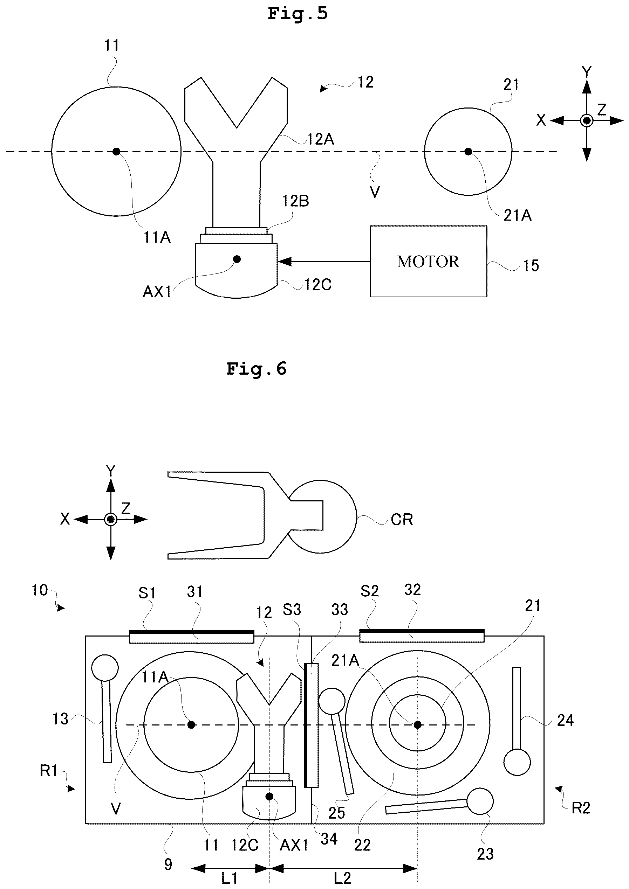

Next, a configuration of the auxiliary robot 12 of the present embodiment will be described with reference to FIG. 5 and the like. FIG. 5 is a plan view for explaining the configuration of the auxiliary robot according to the present embodiment. As illustrated in FIG. 5, the auxiliary robot 12 includes a hand 12A that holds the substrate W in a horizontal attitude, an expansion and contraction arm 12B that is extendable and contractible, and supports the hand 12A at a distal end portion, and a robot base 12C connected to a proximal end portion of the expansion and contraction arm 12B. The expansion and contraction arm 12B is extendable and contractible, and a distance (arm length) between the hand 12A and the robot base 12C can be changed. Such an expansion and contraction operation of the expansion and contraction arm 12B is realized by a slider incorporated in the expansion and contraction arm 12B. The slider corresponds to an arm length adjustment mechanism of the present invention, and is configured to change a turning radius of the hand 12A by changing the arm length of the expansion and contraction arm 12B.

The auxiliary robot 12 is characterized in that the liquid-filled substrate W can be conveyed.

The robot base 12C is provided adjacent to the partition wall 34. The expansion and contraction arm 12B corresponds to a substrate conveyance arm of the present invention, and is movably supported by the robot base 12C.

The hand 12A is configured to acquire the substrate W placed on a plate 11 described later from above. That is, the hand 12A is above the supporting substrate W. The hand 12A is supported by the expansion and contraction arm 12B and holds the substrate W. The hand 12A approaches the substrate W from above when supporting the substrate W. The hand 12A corresponds to an upper hand of the present invention.

The robot base 12C is provided with a reference axis AX1 of rotation, and the robot base 12C can turn and move the hand 12A by rotating about the reference axis AX1. Therefore, the reference axis AX1 faces the vertical direction Z. Such a rotational operation of the robot base 12C is realized by the motor 15. The motor 15 corresponds to an arm turning mechanism of the present invention, and is configured to turn the expansion and contraction arm 12B with reference to the robot base 12C.

A positional relationship among the plate 11, the vacuum chuck 21, and the auxiliary robot 12 will be described. The auxiliary robot 12 is at a position separated in the Y direction from a virtual straight line V connecting the plate 11 and the vacuum chuck 21. More specifically, the robot base 12C of the auxiliary robot 12 is located at a position separated from the virtual straight line V in the Y direction. By disposing the plate 11, the auxiliary robot 12, and the vacuum chuck 21 in a zigzag manner without disposing them in a straight line, the distance between the plate 11 and the vacuum chuck 21 can be shortened, and the substrate processing chamber 10 can be shortened in the X direction. Such an arrangement of the auxiliary robot 12 has an effect of reducing the footprint of the substrate processing apparatus 1. Note that the virtual straight line V is a straight line connecting the center of the plate 11 and the center of the vacuum chuck 21 in plan view, and extends in the X direction.

Furthermore, as illustrated in FIG. 6, the auxiliary robot 12 is provided on the side opposite to the center robot CR across a virtual straight line V connecting the plate 11 and the vacuum chuck 21. More specifically, the robot base 12C of the auxiliary robot 12 is provided on the side opposite to the center robot CR across the virtual straight line V. With such a configuration, the auxiliary robot 12 does not hinder the substrate conveyance operation to the substrate processing chamber 10 by the center robot CR. Note that the virtual straight line V is a virtual line connecting the center point 11A of the plate 11 and the center point 21A of the vacuum chuck 21, and faces the X direction. The plate 11 and the vacuum chuck 21 are arranged such that the virtual straight line V faces the X direction.

Furthermore, as illustrated in FIG. 6, a distance L1 between the plate 11 and the auxiliary robot 12 in the X direction is shorter than a distance L2 between the vacuum chuck 21 and the auxiliary robot 12 in the X direction. Specifically, a distance L1 between the center point 11A of the plate 11 and the reference axis AX1 set in the robot base 12C in the X direction is shorter than a distance L2 between the center point 21A of the vacuum chuck 21 and the reference axis AX1 in the X direction. With such a configuration, the auxiliary robot 12 can be reliably disposed in the first processing chamber R1 having the plate 11.

The distance between the plate 11 and the auxiliary robot 12 is shorter than the distance between the vacuum chuck 21 and the auxiliary robot 12. Specifically, the distance in the X direction between the center point 11A of the plate 11 and the reference axis AX1 set in the robot base 12C is shorter than the distance L2 in the X direction between the center point 21A of the vacuum chuck 21 and the reference axis AX 1.

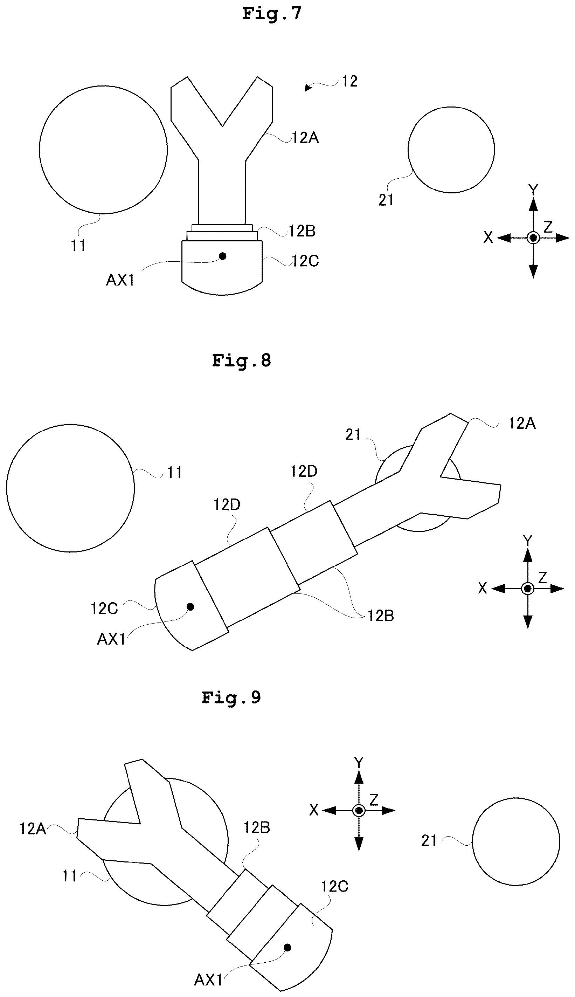

A more specific operation of the auxiliary robot 12 of the present embodiment will be described with reference to FIG. 7. FIG. 7 illustrates a state in which the expansion and contraction arm 12B is most contracted. The expansion and contraction arm 12B is in such a state, for example, in a case where the hand 12A is directed in the Y direction. As illustrated in FIG. 6, the hand 12A at this time is at a position facing the center robot CR. FIG. 7 illustrates a state of the auxiliary robot 12 during execution of the first processing or the second processing.

FIG. 8 illustrates a state in which the expansion and contraction arm 12B is most extended. The expansion and contraction arm 12B is configured by assembling the sub arms 12D in a telescopic manner, and the expansion and contraction operation of the expansion and contraction arm 12B is realized by relative movement between the sub arms 12D. The expansion and contraction arm 12B is in such a state, for example, in a case where the hand 12A reaches the vacuum chuck 21 in the second processing chamber R2.

In addition, as illustrated in FIG. 9, the expansion and contraction arm 12B may have an intermediate length longer than the shortest case illustrated in FIG. 7 and shorter than the longest case illustrated in FIG. 8. The expansion and contraction arm 12B is in such a state, for example, in a case where the hand 12A reaches the plate 11 in the first processing chamber R1.

### <6. Substrate Conveyance of Auxiliary Robot>

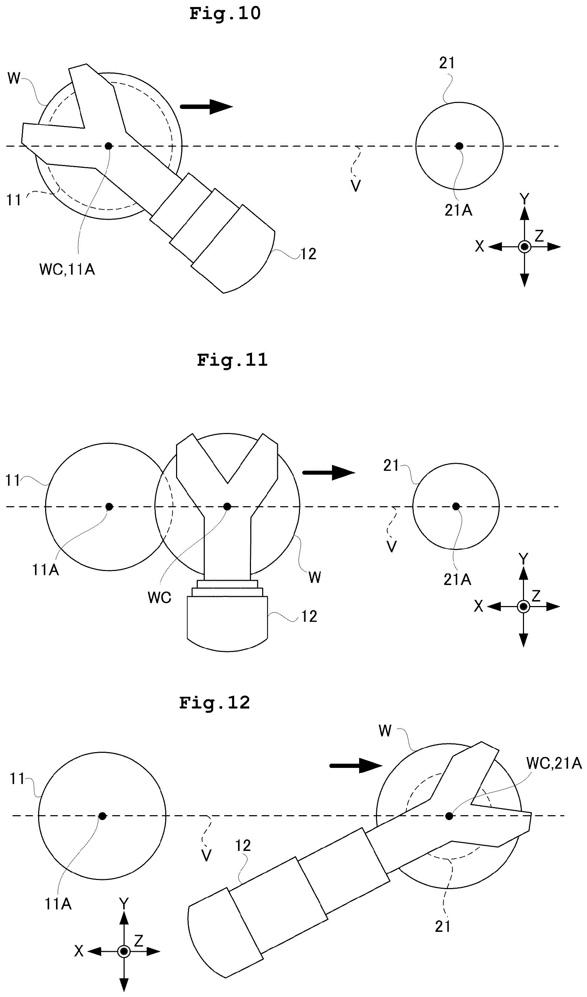

FIG. 10 illustrates an operation in which the auxiliary robot 12 conveys the substrate W. The auxiliary robot 12 has a function of conveying the substrate W supported by the plate 11 to the vacuum chuck 21. FIG. 10 illustrates a state where the auxiliary robot 12 pulls up the substrate W on the plate 11 from the plate 11. Since the substrate W at this time moves in the vertical direction Z, in a state where the auxiliary robot 12 pulls up the substrate W, a state where the center point 11A of the plate 11 coincides with the center point WC of the substrate W in plan view is maintained.

FIG. 11 illustrates the subsequent state. The auxiliary robot 12 turns the expansion and contraction arm 12B in a direction away from the plate 11 while contracting the expansion and contraction arm 12B.

FIG. 12 illustrates the subsequent state. The auxiliary robot 12 turns the expansion and contraction arm 12B in a direction away from the plate 11 while extending the expansion and contraction arm 12B. FIG. 12 illustrates a state in which the auxiliary robot 12 places the substrate W on the vacuum chuck 21. Since the substrate W at this time moves in the vertical direction Z, the auxiliary robot 12 conveys the substrate W to a position where the center point WC of the substrate W coincides with the center point 21A of the vacuum chuck 21 in plan view. Then, the auxiliary robot 12 lowers the substrate W while maintaining a state in which the center point 21A coincides with the center point WC of the substrate W in plan view. In this manner, the auxiliary robot 12 places the substrate W on the auxiliary robot 12.

Since the auxiliary robot 12 moves the substrate W linearly in the X direction, this point will be described. As described with reference to FIG. 6, the virtual straight line V connecting the center point 11A of the plate 11 and the center point 21A of the vacuum chuck 21 extends in the X direction. The substrate W is moved with reference to the virtual straight line V. That is, the auxiliary robot 12 always positions the center point WC of the substrate W on the virtual straight line V to realize the conveyance of the substrate W. The control unit 101 controls the auxiliary robot 12. That is, the control unit 101 is configured to control the motor 15 and the expansion and contraction arm 12B, for example. The control unit 101 controls the motor 15 and the expansion and contraction arm 12B to linearly move the substrate W from the plate 11 to the vacuum chuck 21. With this configuration, the moving distance of the substrate W is minimized, and the substrate W can be quickly conveyed.

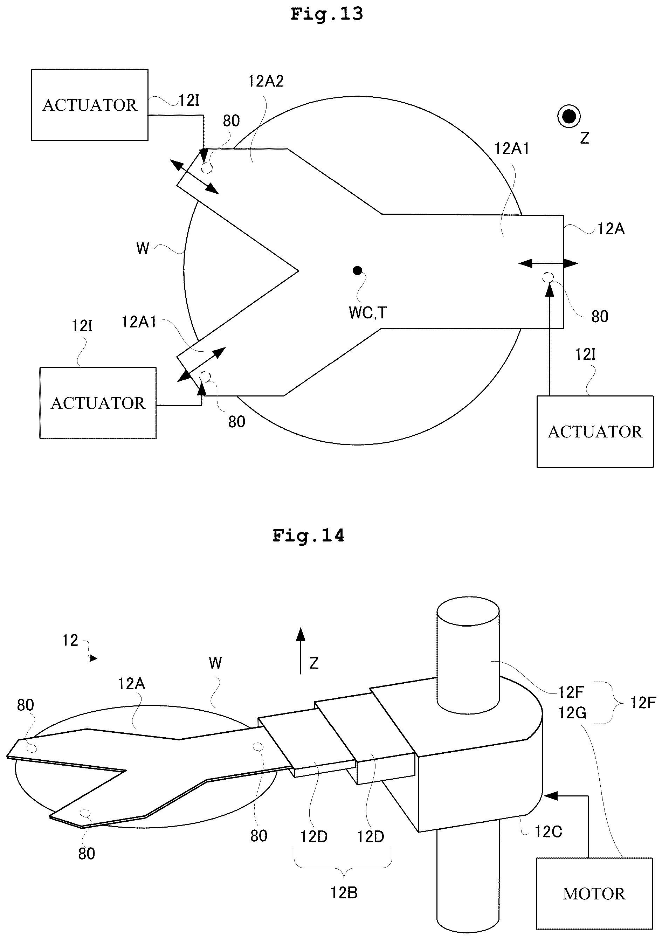

Note that the control unit 101 controls the elevator 12E, the expansion and contraction arm 12B, and the motor 15 to control the vertical movement and the horizontal movement of the hand 12A. Similarly, the control unit 101 controls the actuator 12I to displace the support member 80 between the open state and the closed state (See FIGS. 13 and 14).

### <7. Configuration of Hand of Auxiliary Robot>

FIG. 13 is a plan view for explaining a configuration of a hand of the auxiliary robot according to the present embodiment. As illustrated in FIG. 13, the hand 12A has a flat plate shape orthogonal to the vertical direction Z. The hand 12A includes a base portion 12A1 extending in a predetermined direction, a first blade 12A2 and a second blade 12A3 branching from the base portion and extending horizontally in a Y-shape.

The hand 12A is positioned above the substrate W when supporting the substrate W. With this configuration, the hand 12A can acquire the substrate W held by the center robot CR. Details of such circumstances will be described later.

Furthermore, the auxiliary robot 12 needs to cause the hand 12A to change the state between the support state and the support release state of the substrate W so that the substrate W can be pulled up and placed. FIG. 14 is a perspective view for explaining a vertical movement mechanism of the auxiliary robot according to the present embodiment. FIG. 14 illustrates the shape of the hand 12A and the configuration for changing the state.

The hand 12A of the present embodiment includes a support member 80 that abuts on and supports the substrate W. Since the hand 12A of the present embodiment is above the substrate W when supporting the substrate W, the support member 80 is configured to hang down from the hand 12A. The support member 80 is provided at each of the base portion of the hand 12A, the tip of the first blade, and the tip of the second blade. Therefore, three support members 80 are provided on the hand 12A. Each of the support members 80 includes an actuator 12I that moves the support member 80 with respect to the hand 12A. The actuator 12I causes the support member 80 to move forward and backward with reference to the branch point T of the first blade 12A2 and the second blade 12A3.

When the hand 12A supports the substrate W, the three support members 80 are in a closed state close to the branch point T. When the hand 12A releases the support of the substrate W, the three support members 80 are in an open state separated from the branch point T. The actuator 12I corresponds to an opening and closing mechanism of the present invention, and is configured to change the support member 80 from the open state to the closed state by changing the positional relationship between the support members 80.

Note that the branch point T coincides with the center point WC of the substrate W supported by the hand 12A in plan view.

### <8. Vertical Movement of Hand of Auxiliary Robot>

Furthermore, the auxiliary robot 12 needs to move the hand 12A up and down so as to be able to lift and place the substrate W. FIG. 14 illustrates a configuration in which the hand 12A moves vertically.

The robot base 12C of the present embodiment is supported by the elevator 12E. The elevator 12E includes a vertical member 12F extending in the vertical direction Z and a motor 12G, and moves the robot base 12C vertically. Since the robot base 12C supports the hand 12A via the expansion and contraction arm 12B, the hand 12A moves vertically following the robot base 12C. The elevator 12E corresponds to a hand vertical movement mechanism of the present invention, and moves the hand 12A vertically.

### <9. Horizontal Movement of Hand of Auxiliary Robot>

The expansion and contraction arm 12B and the motor 15 cooperate to horizontally move the hand 12A. The expansion and contraction arm 12B and the motor 15 correspond to a hand horizontal movement mechanism in the present invention.

### <10. Hand of Center Robot>

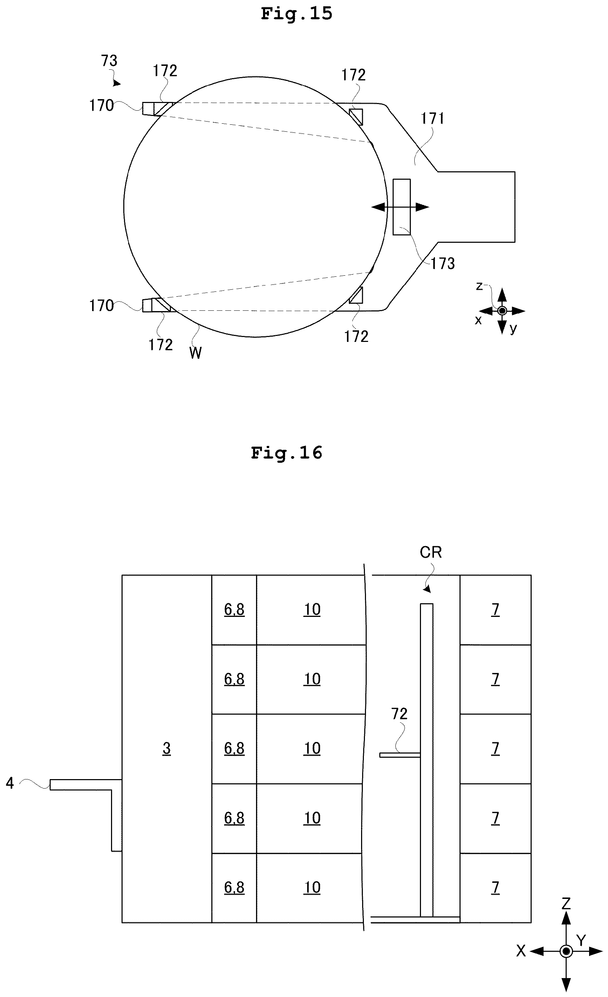

FIG. 15 illustrates the hand 73 included in the center robot CR. The hand 73 of the present embodiment is configured to grip the substrate W in a horizontal attitude. That is, the hand 73 includes two blades 170 and a base member 171 connected to the base portion of each blade 170. A guide 172 that abuts on the substrate W is provided at a distal end portion and a proximal end portion of the blade 170, and the hand 73 supports the substrate W via the guide 172. The guide 172 includes a wall portion abutting on a bevel portion of the substrate W.

A pusher portion 173 is on the base member 171 and can move in the extending direction of the blade 170. When the pusher portion 173 moves to the tip of the blade 170, the pusher portion 173 abuts on the end portion of the substrate W. Then, the bevel portion of the substrate W abuts on the wall portion of the guide 172 at the tip of the blade 170. In this manner, the substrate W is sandwiched between the wall portion of the guide 172 and the pusher portion 173 to be sandwiched by the hand 73. Note that FIG. 15 illustrates a state in which the pusher portion 173 is located away from the tip of the blade 170 and the substrate W is not yet sandwiched by the hand 73.

### <11. Stacking Arrangement of Substrate Processing Chambers>

FIG. 16 is a side view for explaining a stacked state of the substrate processing chamber according to the present embodiment. As illustrated in FIG. 16, the substrate processing chambers 10 are stacked in the vertical direction Z in the substrate processing apparatus 1. Accordingly, the housings 9 are also stacked in the vertical direction Z. Since the auxiliary robot 12 is built in the substrate processing chamber 10, the number of the auxiliary robots 12 provided in the substrate processing apparatus 1 is equal to the number of the substrate processing chambers 10. On the other hand, the hand 73 of the center robot CR can move not only in the X direction but also in the Z direction, and accesses each of the substrate processing chambers 10 to carry the substrate W into and out of the substrate processing chamber 10.

### <12. Substrate Processing by Substrate Processing Chamber>

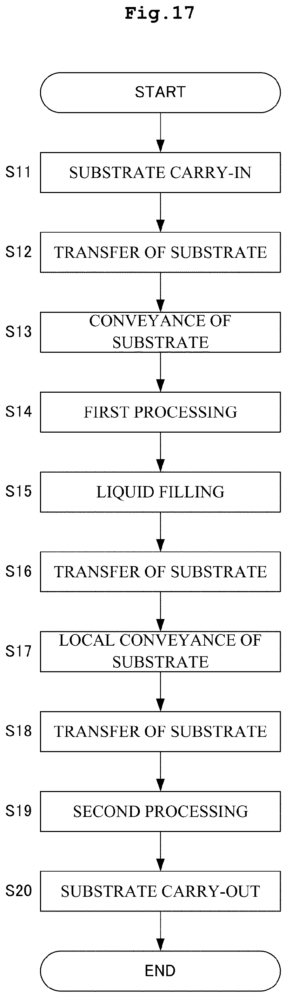

FIG. 17 is a flowchart for explaining a substrate processing method by the substrate processing chamber 10. Hereinafter, the flow of the substrate in the substrate processing chamber will be described with reference to the flowchart.

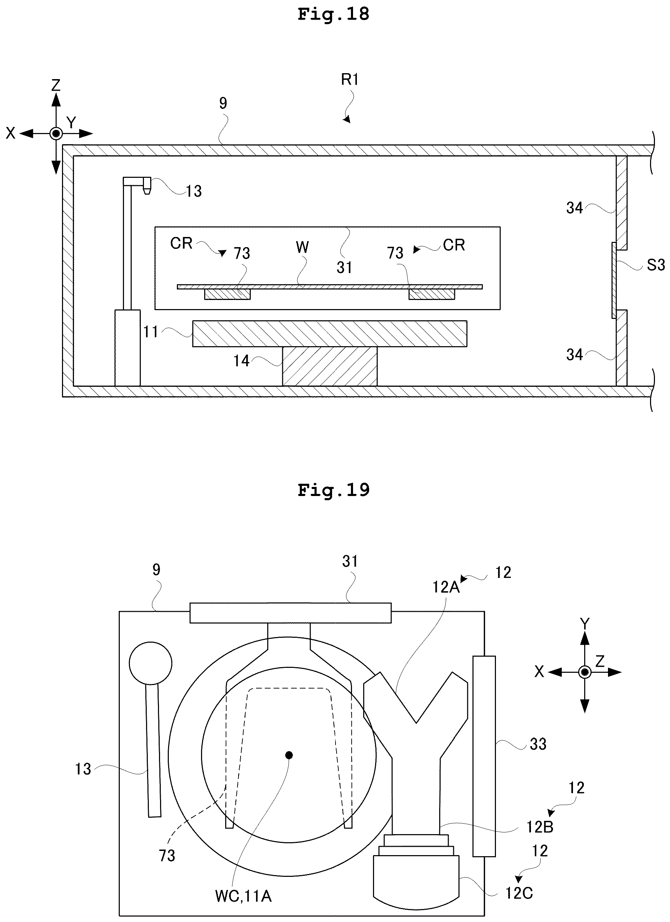

Step S11: As illustrated in FIG. 18, the center robot CR conveys the unprocessed dry substrate W placed in the path 72 to the first processing chamber R1 of the substrate processing chamber 10. At this time, the center robot CR inserts the hand 73 holding the substrate W into the substrate processing chamber 10 from the Y direction through the first opening 31 in the open state. Therefore, the first shutter S1 at this time is in the open state. The pusher portion 173 at this time is close to the substrate W, and the substrate W is gripped by the pusher portion 173 and the guide 172.

On the other hand, FIG. 19 illustrates a subsequent state, and is a plan view of the substrate W when the pusher portion 173 of the hand 73 is moved away from the substrate W from the state of FIG. 18. That is, the substrate W at this time is not gripped in a state of being placed on the hand 73. The center point WC of the substrate W at this time coincides with the center point 11A of the plate 11 in plan view.

Note that the auxiliary robot 12 in step S11 is in a state where the expansion and contraction arm 12B is most contracted in a state where the hand 12A is directed in the Y direction. The liquid supply nozzle 13 is retracted from the substrate W by turning the arm 13B.

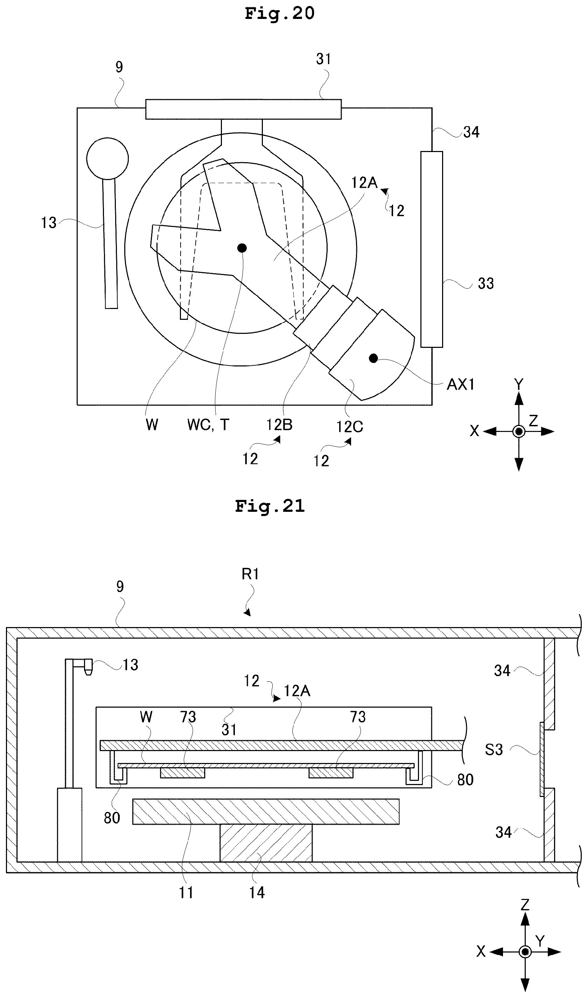

Thereafter, as illustrated in FIG. 20, the auxiliary robot 12 turns the hand 12A around the reference axis AX1 set in the robot base 12C. At this time, the hand 12A turns counterclockwise. While performing such an operation, the auxiliary robot 12 extends the expansion and contraction arm 12B. By such an operation, the hand 12A moves to above the substrate W. The branch point T of the hand 12A at this time coincides with the center point WC of the substrate W in plan view.

Step S12: Thereafter, as illustrated in FIG. 21, the substrate W is transferred between the center robot CR and the auxiliary robot 12. The auxiliary robot 12 supports the substrate W held by the hand 73 of the center robot CR via the support member 80. The substrate W at this time is supported by both the hand 73 of the center robot CR and the hand 12A of the auxiliary robot 12.

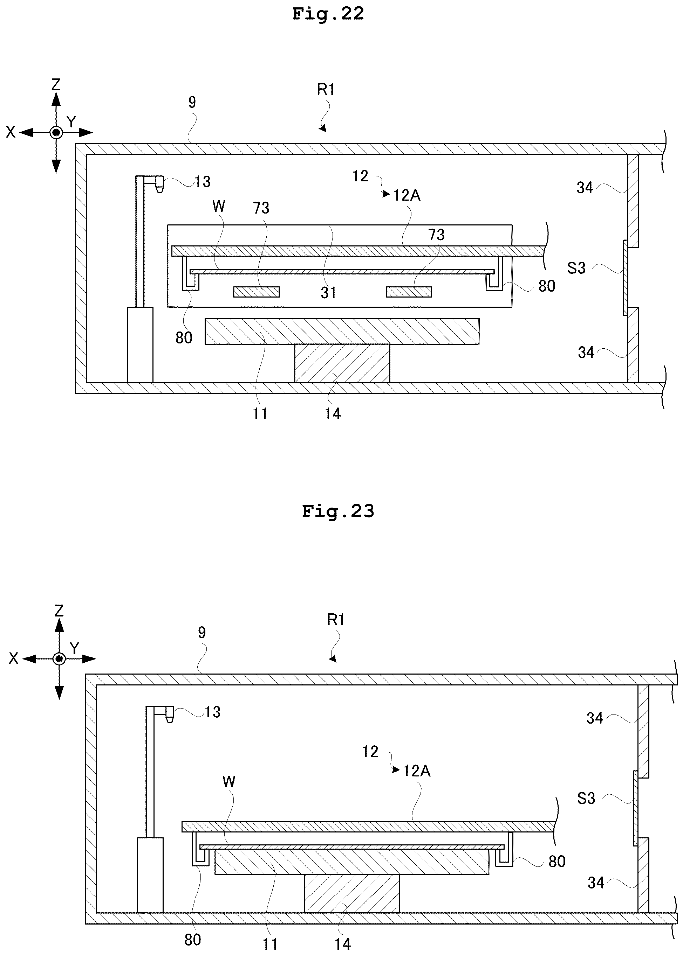

In this state, when the elevator 12E raises the hand 12A as illustrated in FIG. 22, the substrate W is supported only by the hand 12A. In this manner, the substrate W is transferred between the center robot CR and the auxiliary robot 12. Thereafter, the hand 73 of the center robot CR leaves the substrate processing chamber 10 through the first opening 31. This step corresponds to a substrate transfer process of the present invention. The substrate transfer process is performed by the hand 12A of the auxiliary robot 12 located above the substrate W acquiring the substrate W held by the hand 73 of the center robot CR located below the substrate W. In this manner, the auxiliary robot 12 acquires the substrate W supported by the hand 73 by the center robot CR with the hand 12A.

Step S13: Thereafter, the auxiliary robot 12 lowers the hand 12A to convey the substrate W held by the auxiliary robot 12 to the plate 11 as illustrated in FIG. 23. Thereafter, the hand 12A of the auxiliary robot 12 rises after retracting the support member 80 and retracts from the plate 11. The auxiliary robot 12 returns to the state described in step S11. That is, the auxiliary robot 12 is in a state where the expansion and contraction arm 12B is most contracted in a state where the hand 12A is directed in the Y direction. This step corresponds to a first conveyance process of the present invention. The first conveyance process is performed by the hand 12A of the auxiliary robot placing the substrate on the plate 11 in the first processing unit.

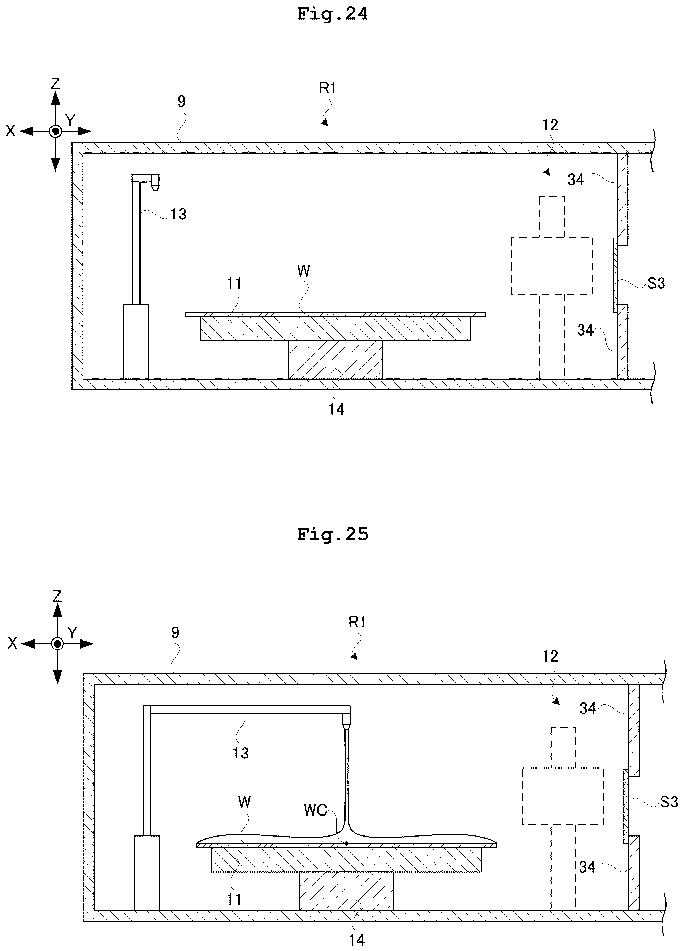

Step S14: Thereafter, as illustrated in FIG. 24, electrolytic etching is performed on the substrate W using the plate 11. At this time, the first shutter S1 and the separation shutter S3 are in a closed state. The electrolytic etching corresponds to first processing in the present invention. This step S14 corresponds to a first processing process of the present invention.

Step S15: After the electrolytic etching, pure water or isopropyl alcohol (IPA) is ejected from the liquid supply nozzle 13 toward the substrate W as illustrated in FIG. 25. Therefore, the substrate W is in a liquid-filled state. In the liquid supply nozzle 13 at this time, the arm 13B is turned from the state of FIG. 23, and the distal end portion 13A is moved to a position coinciding with the center point WC of the substrate W in plan view. This step S15 corresponds to a liquid filling process of the present invention.

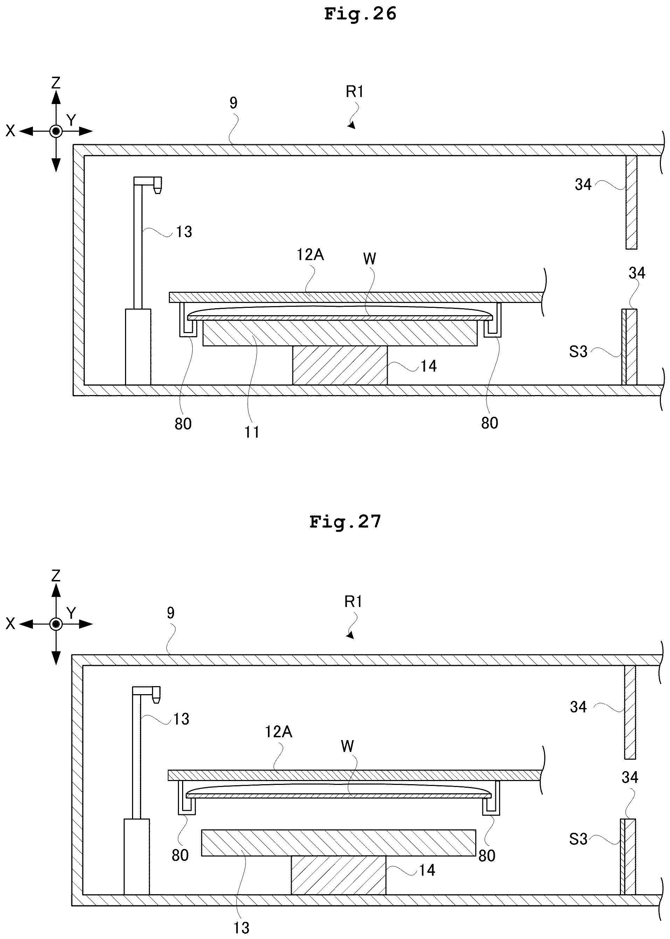

Step S16: Thereafter, as illustrated in FIG. 26, the substrate W is transferred between the auxiliary robot 12 and the plate 11. The auxiliary robot 12 supports the substrate W held by the plate 11 via the support member 80. The substrate W at this time is supported by both the plate 11 and the hand 12A of the auxiliary robot 12.

In this state, when the hand 12A rises as illustrated in FIG. 27, the substrate W is supported only by the hand 12A. In this manner, the substrate W is transferred between the auxiliary robot 12 and the plate 11. The separation shutter S3 is in an open state prior to the inter-chamber conveyance of the substrate W. Note that the elevator 12E realizes a rising operation of the hand 12A.

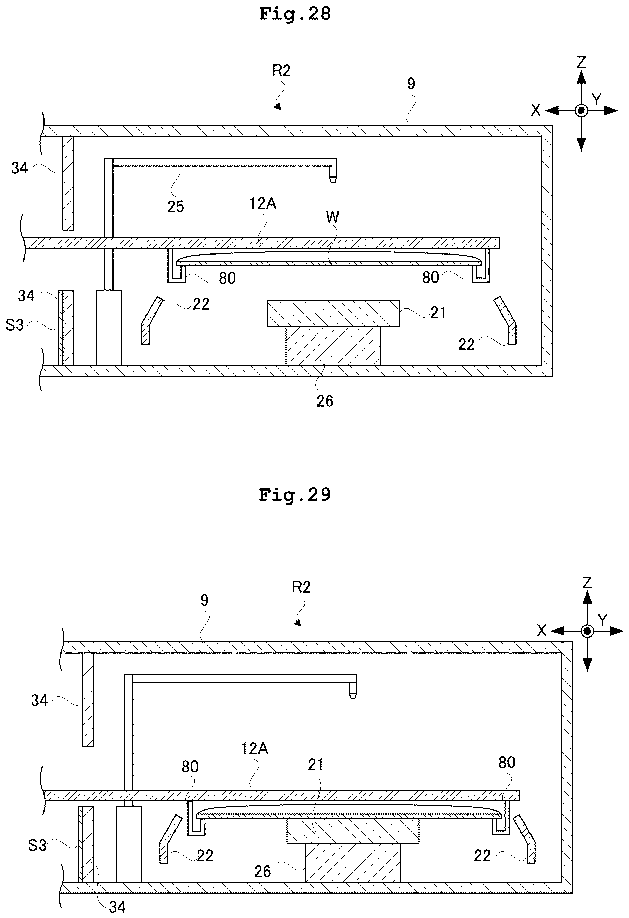

Step S17: The substrate W in the liquid-filled state is conveyed from the first processing chamber R1 to the second processing chamber R2 by the auxiliary robot 12. FIGS. 10, 11, and 12 are plan views of the substrate conveyance at this time. FIG. 28 illustrates a case where the substrate W in the liquid-filled state reaches the second processing chamber R2, and corresponds to the state of FIG. 12. The separation shutter S3 is in an open state during the substrate conveyance by the auxiliary robot 12. This step S17 is local conveyance of the substrate and corresponds to a second conveyance process of the present invention. The second conveyance process is performed by conveying the substrate W held by the hand 12A of the auxiliary robot 12 to the second processing unit.

Step S18: Thereafter, as illustrated in FIG. 29, the substrate W is transferred between the auxiliary robot 12 and the vacuum chuck 21. The auxiliary robot 12 supports the substrate W in the liquid-filled state via the support member 80. The substrate W at this time is supported by both the vacuum chuck 21 and the hand 12A of the auxiliary robot 12. Note that the cup 22 at this time is in a lowered state. The cup 22 in the lowered state does not come into contact with the hand 12A of the auxiliary robot 12.

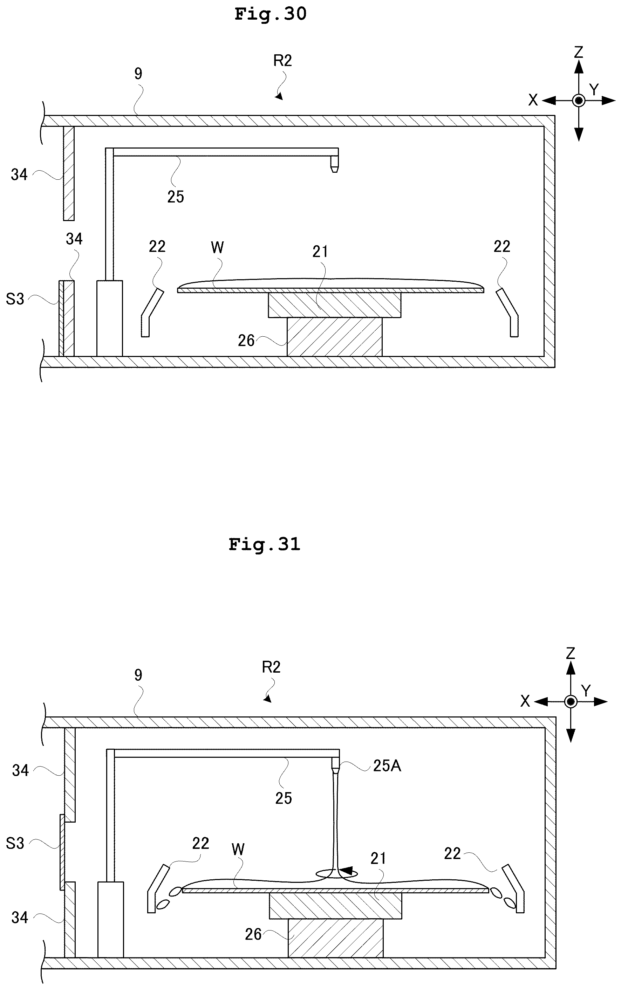

In this state, as illustrated in FIG. 30, the hand 12A of the auxiliary robot 12 is retracted from the vacuum chuck 21. In this manner, the substrate W is supported only by the vacuum chuck 21.

Step S19: FIG. 31 illustrates a state in which the second processing is performed on the substrate W. The second processing includes, for example, substrate cleaning processing or substrate drying processing. The second processing unit performs cleaning processing on the substrate W on which the substrate processing has been completed by the first processing unit, using the liquid supplied from the liquid supply mechanism 7. The second processing unit performs drying processing on the substrate W on which the substrate processing has been completed. This step S19 corresponds to a second processing process of the present invention.

FIG. 31 illustrates a state in which the substrate cleaning processing out of these processing is executed. At this time, the distal end portion 25A of the liquid supply nozzle 25 is moved to the center position of the substrate W and ejects pure water. In the substrate cleaning processing, the vacuum chuck 21 sucks and holds the substrate W, and rotates the substrate W thereon. The pure water ejected toward the rotating substrate W flows out to the substrate end portion by the rotational force of the substrate W. The cup 22 at this time is in a rising state so as to be able to receive the pure water. Note that, during the second processing, the separation shutter S3 is in a closed state.

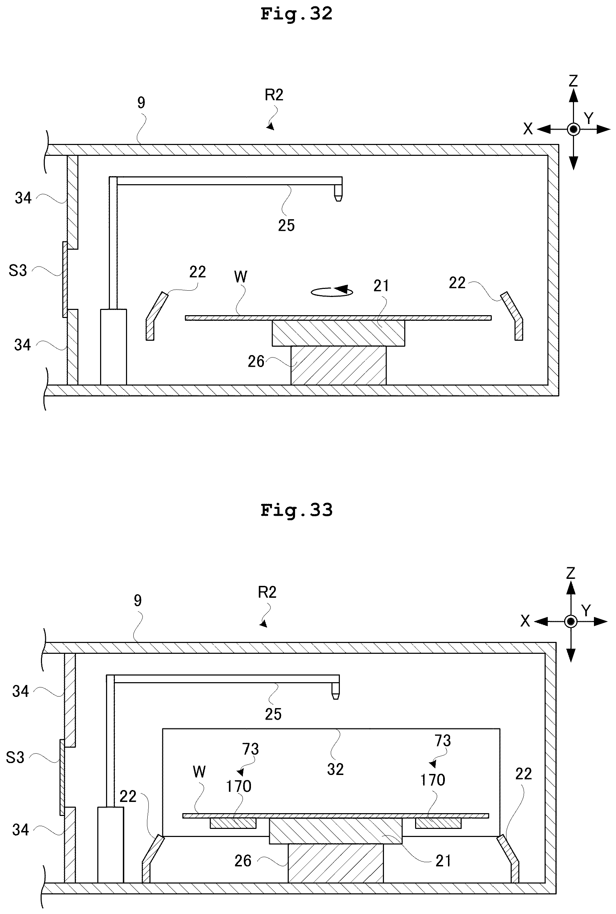

FIG. 32 illustrates a state when substrate drying processing, which is a type of the second processing, is performed on the substrate W. At this time, pure water is not ejected from the liquid supply nozzle 25. The vacuum chuck 21 rotates the substrate W to shake off the pure water adhering to the upper surface of the substrate to perform spin drying. Thus, the second processing is completed for the substrate W.

Step S20: The dried substrate W is carried out of the substrate processing chamber 10 by the center robot CR. FIG. 33 illustrates a state where the hand 73 of the center robot CR is about to carry out the substrate W on the vacuum chuck 21. The hand 73 moves in the Y direction from a position below the lower surface of the substrate W and is located on the lower surface of the substrate W. At this time, a gap is provided between the lower surface of the substrate W and the hand 73.

FIG. 33 illustrates a state where the hand 73 is raised from this state, and illustrates a state where the substrate W is held by both the vacuum chuck 21 and the hand 73. Note that the vacuum chuck 21 at this time stops suction of the substrate W. The second shutter S2 capable of closing the second opening 32 is in the open state, and the hand 73 of the center robot CR can enter the substrate processing chamber 10 via the second opening 32. The cup 22 at this time is in a lowered state and does not come into contact with the hand 73.

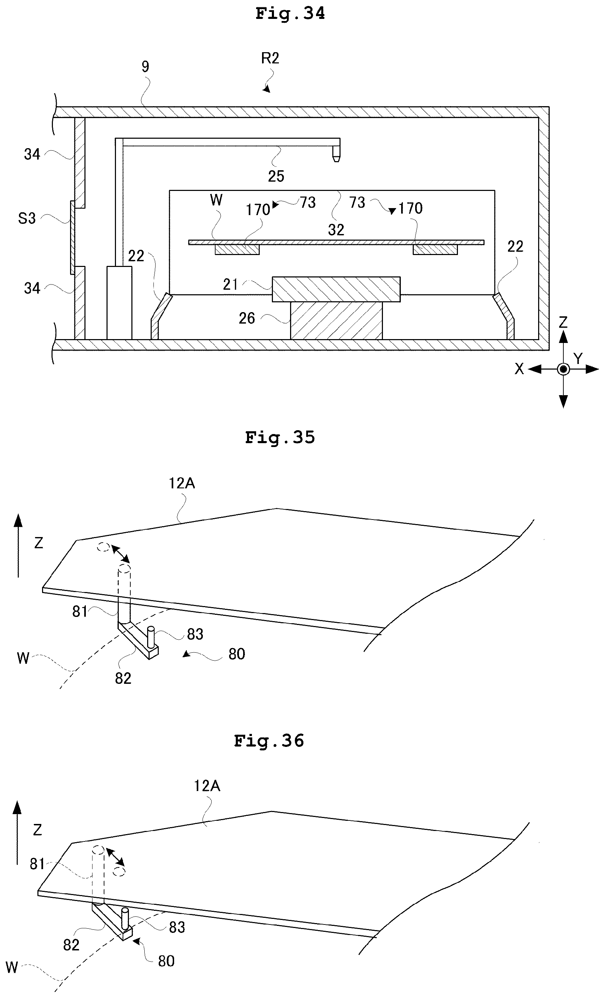

FIG. 34 illustrates a state when the hand 73 is raised to above the vacuum chuck 21. The substrate W at this time is supported only by the hand 73. In this state, the pusher portion 173 is in a closed state, and the substrate W is gripped by the hand 73. When the center robot CR moves the substrate W in the Y direction through the second opening 32 and pulls out the substrate W from the substrate processing chamber 10, a series of substrate conveyance ends. This step corresponds to a carry-out process of the present invention.

### <13. Support Member>

Hereinafter, the support member 80 of the hand 12A of the present embodiment will be described. FIG. 35 is a perspective view for explaining the configuration of the support member 80 of the present embodiment. The support member 80 is a member that is provided on the lower surface of the hand 12A and directly contacts the substrate W. That is, the support member 80 extends downward from a body of the hand 12A and is in contact with the lower surface of the substrate away from the peripheral edge of the substrate to support the substrate.

As described with reference to FIG. 13, the plurality of support members 80 is provided on the hand 12A. In the present embodiment, each of the three support members 80 is in contact with the lower surface of the substrate W to support the substrate W. The support member 80 is provided on each of the base portion 12A1 of the hand 12A and the two blades 12A2 and 12A3 provided on the hand 12A.

The configuration of the support member 80 will be described with reference to FIG. 35. The support member 80 includes a coupling member 81 extending downward from the body of the hand 12A. The horizontal member 82 is a member extending from the lower end of the coupling member 81 in the center direction of the substrate W. The support pin 83 is a member that protrudes upward from the distal end portion of the horizontal member 82 and abuts on the lower surface of the substrate W. The support pin 83 abuts on the lower surface position of the substrate that has entered radially inward from the peripheral edge of the substrate W.

The coupling member 81 can be displaced with respect to the body of the hand 12A by the actuator 12I provided in the auxiliary robot 12. That is, the support member 80 can be displaced from a closed state close to the substrate W (see FIG. 35) to an open state separated from the substrate W (see FIG. 36). The support member 80 at this time can reciprocate in a radial direction (radial direction of the substrate W) orthogonal to the tangential direction of the substrate W by the actuator 12I. Note that the support member 80 may be reciprocally rotated by 180° with the coupling member 81 as a rotation axis.

When the substrate W is supported, the support member 80 is in the closed state as described with reference to FIG. 35. Therefore, the three support members 80 are simultaneously in a closed state to support the substrate W in cooperation. Furthermore, when the substrate is opened, the support member 80 is in the open state as described with reference to FIG. 36. Therefore, the three support members 80 are simultaneously in an open state to open the substrate W in cooperation.

The support pin 83 of the support member 80 in the closed state is located below the lower surface of the substrate W. In the closed state, a diameter of the virtual circle formed by connecting the three support pins 83 is smaller than a diameter of the substrate W. On the other hand, the support pin 83 of the support member 80 in the open state is located at a position avoiding below the lower surface of the substrate W. In the open state, the diameter of the virtual circle formed by connecting the three support pins 83 is larger than the diameter of the substrate W.

### <14. Operations of Support Member And Body of Hand>

Hereinafter, the operations of the support member 80 and the body of the hand will be described. The hand 12A of the present embodiment can acquire the substrate W supported by the plate 11 or the center robot CR or can place the substrate W on the vacuum chuck 21. First, an operation when the hand 12A acquires the substrate W will be described.

### <15. Acquisition of Substrate by Hand of Auxiliary Robot>

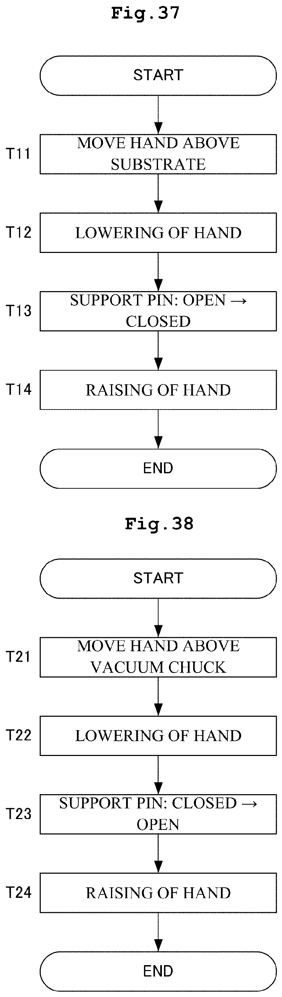

FIG. 37 is a flowchart for explaining how the hand 12A acquires the substrate W. Hereinafter, the operation of the hand 12A for acquiring the substrate W on the plate 11 will be described with reference to FIG. 37. Note that, in the following description, acquisition of the liquid-filled substrate W will be described, but the method of acquiring the substrate W is an example. The hand 12A can also acquire a dry substrate supported by the hand 73 of the center robot CR. The auxiliary robot 12 conveys the substrate W liquid-filled with a predetermined liquid (for example, pure water or IPA) in the first processing chamber R1 to the second processing chamber R2.

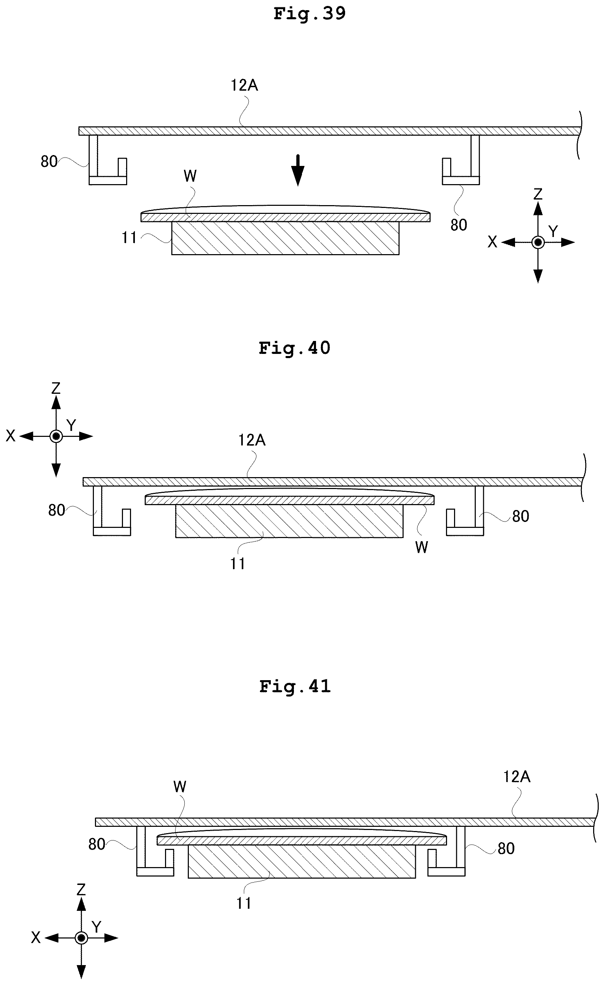

Step T11: As illustrated in FIG. 39, the hand 12A is moved to above the substrate W. At this time, all the support members 80 are in an open state. The movement of the hand 12A at this time is realized by the elevator 12E, the motor 15, and the expansion and contraction arm 12B. The branch point T of the hand 12A at this time coincides with the center point WC of the substrate W in plan view. When the hand 12A acquires the substrate W from the center robot CR, the control unit 101 controls the elevator 12E, the motor 15, and the expansion and contraction arm 12B to move the hand 12A having the support member 80 in the open state above the hand 73 holding the substrate W.

Step T12: Thereafter, the hand 12A is lowered as illustrated in FIG. 40. At this time, the body of the hand 12A does not come into contact with the liquid filled on the upper surface of the substrate W. Furthermore, the tip of the support pin 83 in step T12 is at a position lower than the lower surface of the substrate W. The control unit 101 controls the elevator 12E to lower the hand 12A to a position where the tip of the support pin 83 is lower than the lower surface of the substrate W.

Step T13: Thereafter, the support member 80 becomes in a closed state as illustrated in FIG. 41. Then, the support pins 83 retracted from the substrate W enter below the substrate W. The control unit 101 controls the actuator 12I to bring the support member 80 into a closed state.

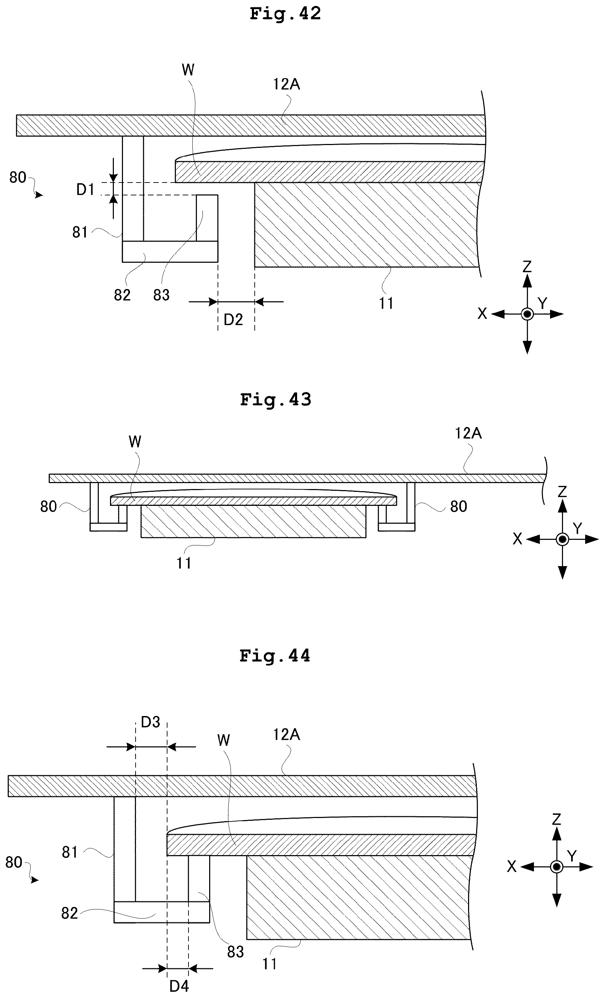

FIG. 42 illustrates a positional relationship between the substrate W and the support member 80 in this step. As illustrated in FIG. 42, a gap D1 is provided between the substrate W and the support pins 83 separated from each other in the vertical direction Z. The presence of the gap D1 prevents the support member 80 from colliding with the substrate W even when the support member 80 is changed from the open state to the closed state.

Furthermore, as illustrated in FIG. 42, in the closed state, gap D2 is provided between support pin 83 and plate 11. The presence of the gap D2 prevents the support pin 83 from colliding with the plate 11.

Step T14: Thereafter, the hand 12A is raised. The rising of the hand 12A is realized by the elevator 12E attached to the auxiliary robot 12.

FIG. 43 illustrates a state in which the distal end of the support pin 83 is in contact with the lower surface of the substrate W as the hand 12A is raised. The substrate W at this time is supported by both the plate 11 and the support pins 83. The control unit 101 controls the elevator 12E to raise the hand 12A and bring the distal end of the support pin 83 into contact with the lower surface of the substrate W.

FIG. 44 illustrates a positional relationship between the substrate W and the support member 80 in this step. As illustrated in FIG. 44, a gap D3 is provided between the end of the substrate W and the coupling member 81. The presence of the gap D3 prevents the liquid filled up on the substrate W from dripping along the coupling member 81 included in the support member 80 in the closed state. In this manner, the support member 80 is separated from the peripheral edge of the substrate.

Furthermore, as illustrated in FIG. 44, in the closed state, a gap D4 is provided between the support pin 83 and the end of the substrate W. The presence of the gap D4 prevents the liquid filled up on the substrate W from dripping along the support pin 83. The distance between the support pin 83 and the substrate center is longer than the distance between the support pin 83 and the substrate peripheral edge. That is, the gap D4 is only a slight distance from the entire substrate W. In this manner, the support member 80 is separated from the peripheral edge of the substrate.

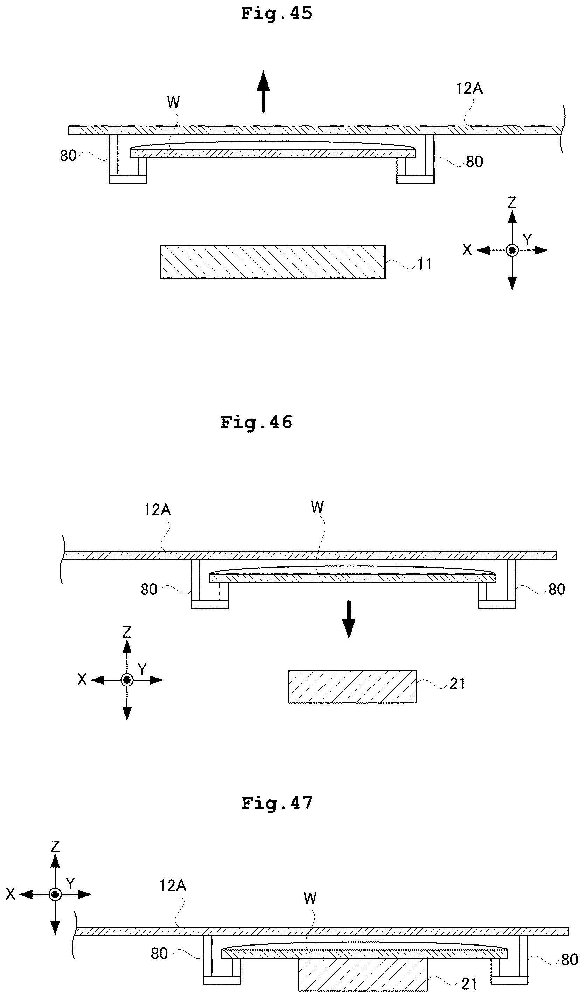

FIG. 45 illustrates a state where the hand 12A raises the substrate W to above the plate 11 from the state of FIG. 43. At this time, the substrate W is supported only by the hand 12A. In this way, the acquisition of the substrate W by the hand 12A in the present embodiment is completed.

### <16. Placement of Substrate by Hand of Auxiliary Robot>

FIG. 38 is a flowchart for explaining how the hand 12A places the substrate W. Hereinafter, the operation of the hand 12A for placing the substrate W on the vacuum chuck 21 will be described with reference to FIG. 38. Note that, in the following description, the placement of the liquid-filled substrates W will be described, but the method of placing the substrates W is an example. The hand 12A can also place a dry substrate supported by the hand 73 of the center robot CR on the plate 11.

Step T21: As illustrated in FIG. 46, the hand 12A is moved to above the vacuum chuck 21 while holding the substrate W. At this time, all the support members 80 are in a closed state. The movement of the hand 12A at this time is realized by the elevator 12E, the motor 15, and the expansion and contraction arm 12B. The branch point T of the hand 12A at this time coincides with the center point 21A of the vacuum chuck 21 in plan view.

Step T22: Thereafter, the hand 12A is lowered as illustrated in FIG. 47. The lowering of the hand 12A is realized by the elevator 12E attached to the auxiliary robot 12. When placing the substrate W on the vacuum chuck 21, the control unit 101 controls the elevator 12E to lower the hand 12A supporting the substrate with the support pin 83 and move the substrate W to the vacuum chuck 21. Note that the control unit 101 performs a similar operation when placing the substrate on the plate 11.

FIG. 47 illustrates a state in which the substrate W is in contact with the vacuum chuck 21 by lowering of the hand 12A. The substrate W at this time is supported by both the vacuum chuck 21 and the support pin 83.

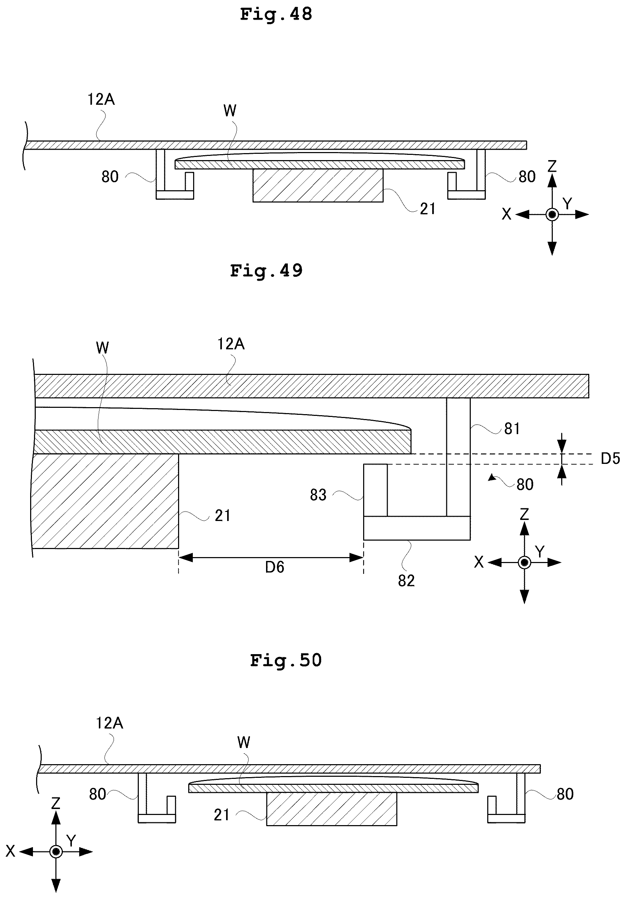

Thereafter, the hand 12A is lowered as illustrated in FIG. 48. At this time, the body of the hand 12A does not come into contact with the liquid filled on the upper surface of the substrate W. Furthermore, the tip of the support pin 83 in step T22 is at a position lower than the lower surface of the substrate W. The control unit 101 controls the elevator 12E to lower the hand 12A to a position where the tip of the support pin 83 is lower than the lower surface of the substrate W.

FIG. 49 illustrates a positional relationship between the substrate W and the support member 80 in this step T22. As illustrated in FIG. 49, a gap D5 is provided between the substrate W and the support pins 83 separated from each other in the vertical direction Z. The presence of the gap D5 prevents the support member 80 from sliding the substrate W even when the support member 80 is changed from the closed state to the open state.

Furthermore, as illustrated in FIG. 49, a gap D6 is provided between the support pin 83 and the vacuum chuck 21 in the closed state. Due to the presence of the gap D6, the support pin 83 does not collide with the vacuum chuck 21.

Step T23: Thereafter, the support member 80 is in an open state as illustrated in FIG. 50. Then, the support pins 83 that have entered below the substrate W are retracted from the substrate W. The control unit 101 controls the actuator 12I to bring the support pin 83 into an open state.

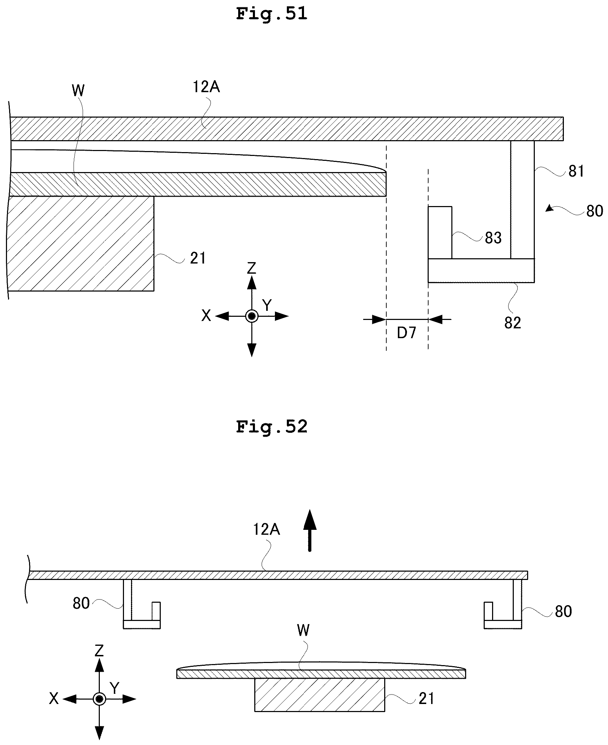

FIG. 51 illustrates a positional relationship between the substrate W and the support member 80 in this step. As illustrated in FIG. 51, a gap D7 is provided between the substrate W and the support pins 83 separated from each other in the horizontal direction. Due to the presence of the gap D7, even when the support member 80 in the open state is moved to the upper side of the substrate W, the support member 80 does not collide with the substrate W.

Step T24: Thereafter, the hand 12A is raised as illustrated in FIG. 52. The rising of the hand 12A is realized by the elevator 12E attached to the auxiliary robot 12. Specifically, the control unit 101 controls the elevator 12E, the motor 15, and the expansion and contraction arm 12B to move the hand 12A upward and horizontally and retract the hand from the substrate W. In this way, the placement of the substrate W by the hand 12A in the present embodiment is completed.

### <17. Exhaust in Substrate Processing Chamber And Member Related Thereto>

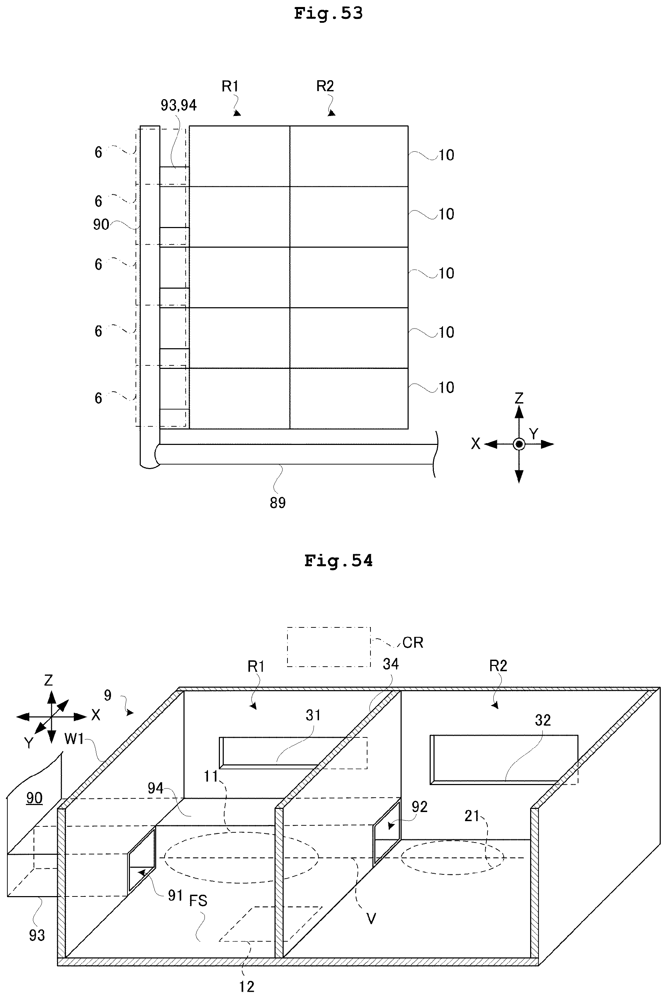

Subsequently, exhaust gas in the substrate processing chamber and members related to the exhaust gas will be described with reference to FIG. 53. The exhaust mechanism 6 of the substrate processing apparatus 1 is provided with an intake and exhaust pipe 90 extending in the vertical direction. The intake and exhaust pipe 90 extends in communication with each of the exhaust mechanisms 6 stacked vertically, and the intake and exhaust pipe 90 communicates with a horizontal exhaust pipe 89 provided in the lower portion of the substrate processing apparatus 1 and extending in the horizontal direction. The horizontal exhaust pipe 89 extends to the outside of the substrate processing apparatus 1 and communicates with an intake pump in the factory.

The intake and exhaust pipe 90 is provided adjacent to the first processing chamber R1 of the substrate processing chamber 10. The substrate processing chamber 10 and the intake and exhaust pipes 90 are connected to each other via a first branch pipe 93 extending in the horizontal direction and a second branch pipe 94 extending in the horizontal direction. The air in the first processing chamber R1 in the substrate processing chamber 10 flows into the intake and exhaust pipe 90 via the first branch pipe 93. Similarly, the air in the second processing chamber R2 in the substrate processing chamber 10 flows into the intake and exhaust pipe 90 via the second branch pipe 94. The air is an example of a gas in the present invention.

As can be seen with reference to FIG. 53, the intake and exhaust pipes 90, the first processing chamber R1, and the second processing chamber R2 are arranged in this order in the horizontal direction and disposed in a line. That is, the intake and exhaust pipe 90 sucks not only the air in the adjacent first processing chamber R1 but also the air in the separated second processing chamber R2.

FIG. 54 explains the configuration of the branch pipe in the substrate processing chamber 10. The first branch pipe 93 extends in the X direction from the intake and exhaust pipe 90 toward the first processing chamber R1, and communicates with a first exhaust opening 91 provided on a wall surface forming the first processing chamber R1 in the housing 9. The first exhaust opening 91 exists on a plane formed by the Y direction and the vertical direction Z. Therefore, the first exhaust opening 91 is provided on a predetermined wall surface W1 orthogonal to the X direction in the housing 9. The first branch pipe 93 is configured to communicate the first processing chamber R1 with the intake and exhaust pipes 90.

The second branch pipe 94 extends in the X direction from the intake and exhaust pipe 90 toward the second processing chamber R2 and communicates with a second exhaust opening 92 provided in the partition wall 34. The second branch pipe 94 penetrates the predetermined wall surface W1, crosses the inside of the first processing chamber R1 in the X direction, and reaches the second exhaust opening 92. The second branch pipe 94 passes through the inside of the first processing chamber R1 starting from the partition wall 34 and is connected to the intake and exhaust pipe 90. The second branch pipe 94 is provided on a floor surface FS of the first processing chamber R1. The second branch pipe 94 is adjacent to the first opening 31. Therefore, the second branch pipe 94 is provided on the side where the center robot CR is disposed inside the first processing chamber R1. The second branch pipe 94 is configured to communicate the second processing chamber R2 with the intake and exhaust pipes 90.

Furthermore, the second branch pipe 94 is provided on the side opposite to the auxiliary robot 12 across the virtual straight line V connecting the first processing unit (plate 11) and the second processing unit (vacuum chuck 21).

On the other hand, the first branch pipe 93 is adjacent to the second branch pipe 94 from the Y direction and is provided at the same height as the second branch pipe 94. The first branch pipe 93 is provided at a position farther from the first opening 31 than the second branch pipe 94.

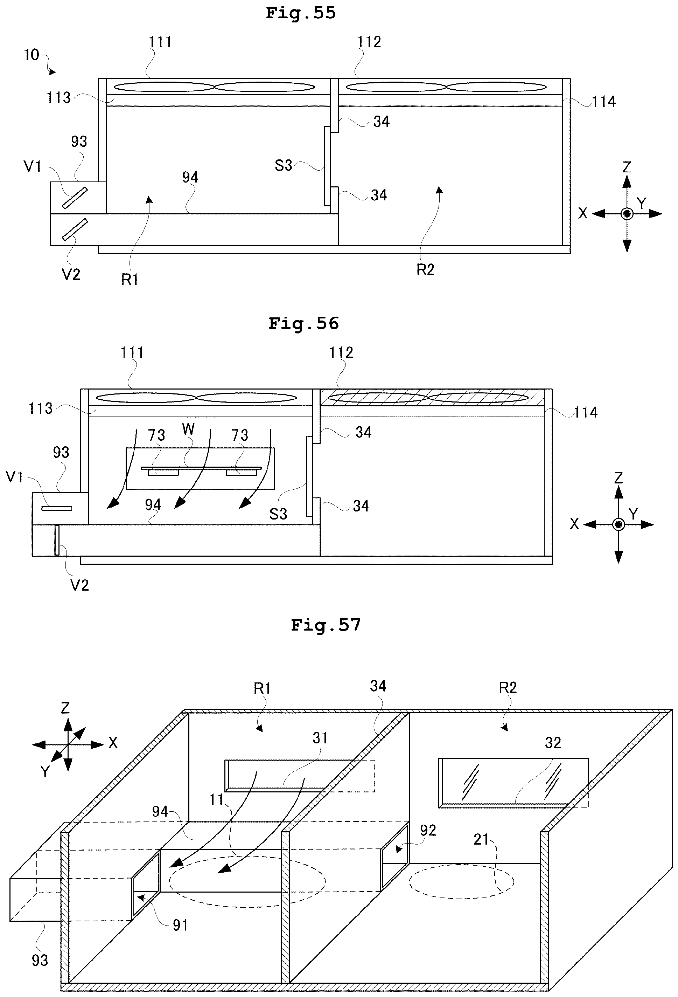

As illustrated in FIG. 55, the substrate processing chamber 10 is provided with a rectifying system that generates an air flow in the processing chamber. The rectifying system includes a first fan 111 provided on a ceiling portion of the first processing chamber R1, a flat plate-shaped first filter 113 attached to the first fan 111, a second fan 112 provided on a ceiling portion of the second processing chamber R2, a flat plate-shaped second filter 114 attached to the second fan 112, a first branch pipe 93, a second branch pipe 94, a first valve V1, and a second valve V2.

The first fan 111 has a plurality of fins and rotates to generate an air flow blown down from above the substrate processing chamber 10 toward the first processing chamber R1. The first filter 113 is provided below the first fan 111, and is configured to remove particles contained in the air flow generated by the first fan 111.

The first valve V1 is an automatic valve that opens and closes according to the operation of the control unit 101, and is located inside the first branch pipe 93. The first valve V1 is configured to control the flow rate of the air passing through the first branch pipe 93.

The second fan 112 has a plurality of fins and rotates to generate an air flow blown down from above the substrate processing chamber 10 toward the second processing chamber R2. The second filter 114 is provided below the second fan 112, and is configured to remove particles contained in the air flow generated by the second fan 112.

The second valve V2 is an automatic valve that opens and closes according to the operation of the control unit 101, and is located inside the second branch pipe 94. The second valve V2 is configured to control the flow rate of the air passing through the second branch pipe 94.

### <18. Operation of First Valve And Second Valve>

Since the intake and exhaust pipe 90 is shared by the first processing chamber R1 and the second processing chamber R2, the first valve V1 and the second valve V2 are controlled in order to reduce the burden on the intake and exhaust pipe 90. FIG. 56 illustrates the operation of the rectifying system when the substrate W is located in the first processing chamber R1. FIG. 56 illustrates a state where the substrate W is carried into the first processing chamber R1 by the center robot CR. In addition, in a case where the substrate W remains in the first processing chamber R1 during the first processing or the like, the rectifying system operates as follows.

In a case where the substrate W is located in the first processing chamber R1, the first valve V1 is in an open state and the second valve V2 is in a closed state. At this time, the first fan 111 is in an operating state, and the second fan 112 is in a stopped state. Therefore, the second fan 112 in this case is not rotating.

In this case, as illustrated in FIG. 56, the air blown down by the first fan 111 passes through the first branch pipe 93 and reaches the intake and exhaust pipe 90.

On the other hand, since the second fan 112 at this time is stopped and the second valve V2 is in a closed state, no air flow is generated in the second processing chamber R2.

Since the passage port 33 at this time is in the closed state, no air flow is generated through the passage port 33.

The case where the substrate W is located in the first processing chamber R1 may be, for example, a case where the first processing is being performed. In this case, the first valve V1 and the second valve V2 are controlled so that the flow rate of the gas flowing through the first branch pipe 93 is larger than the flow rate of the gas flowing through the second branch pipe 94. In the present embodiment, the second valve V2 is in the fully closed state, but the present invention is not limited to this configuration, and the second valve V2 may be in the half-open state. That is, the airflow in the first processing chamber R1 during the first processing cannot be weakened from the guarantee of the processing quality, but the air flow in the second processing chamber R2 that is not processed is not related to the first processing at all. Therefore, the substrate processing apparatus 1 of the present embodiment is configured to stop or weaken the air flow in the second processing chamber R2 during the first processing. In a case where the air flow is generated in the second processing chamber R2 during the first processing, the second fan 112 may be operated or may not be operated.

FIG. 57 illustrates the air flow when the first opening 31 is in the open state. In a case where the first opening 31 is in the open state, in addition to the air flow described with reference to FIG. 56, an airflow from the first opening 31 toward the first exhaust opening 91 is also generated. A case where the first opening 31 is in the open state is a case where the first shutter S1 is in the open state and the substrate W is carried in by the center robot CR. When the substrate W is carried in through the first opening 31, the control unit 101 controls the first valve V1 such that gas flows from the outside toward the first processing chamber R1 through the first opening 31. This prevents the air in the first processing chamber R1 from leaking into the conveyance area (region B) when the substrate W is carried into the first processing chamber R1.

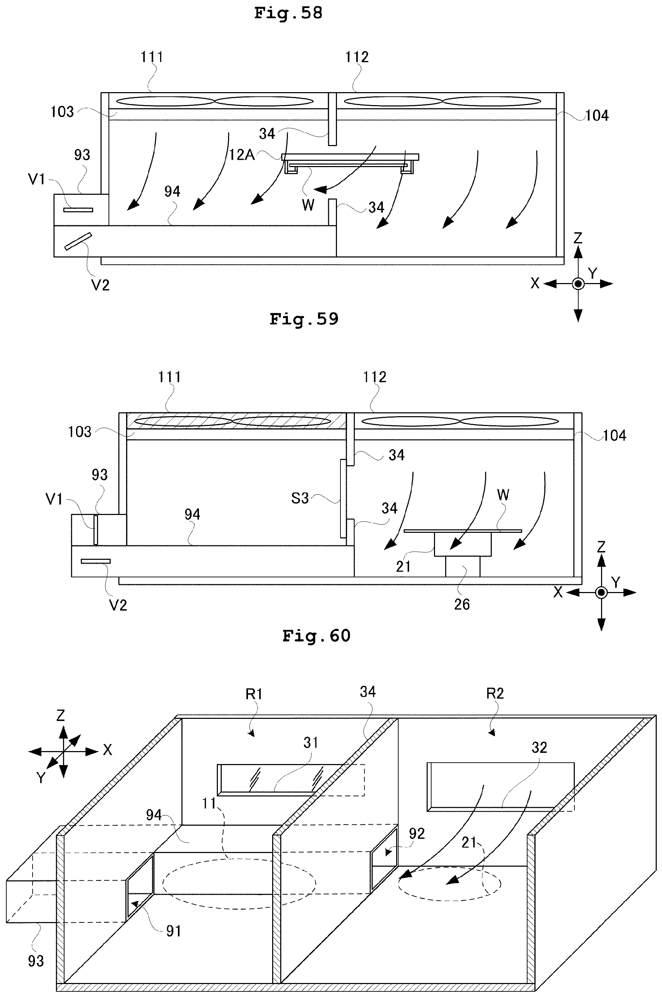

FIG. 58 illustrates the operation of the rectifying system when the separation shutter S3 is in the open state. The case where the separation shutter S3 is in the open state is a case where the auxiliary robot 12 conveys the substrate W from the first processing chamber R1 to the second processing chamber R2. This conveyance is referred to as local conveyance.

In a case where the substrate W is locally conveyed, the first valve V1 is in the open state, and the second valve V2 is in the half-open state. At this time, the first fan 111 and the second fan 112 are in an operating state. The opening degree of the second valve V2 is smaller than the opening degree of the first valve.

In this case, as illustrated in FIG. 58, the air blown down by the first fan 111 passes through the first branch pipe 93 and reaches the intake and exhaust pipe 90. Then, the air blown down by the second fan 112 passes through the second branch pipe 94 and reaches the intake and exhaust pipes 90.

Furthermore, in this case, since the separation shutter S3 is in the open state, an air flow is also generated through the passage port 33 provided in the partition wall 34. Since the suction force of the second branch pipe 94 that sucks the air in the second processing chamber R2 is inferior to the suction force of the first branch pipe 93 that sucks the air in the first processing chamber R1, an air flow is generated from the second processing chamber R2 toward the first processing chamber R1 at the passage port 33. The control unit 101 controls the first valve V1 and the second valve V2 such that air flows from the second processing chamber R2 to the first processing chamber R1 via the passage port 33 when the separation shutter S3 is in an open state and the substrate W is passed through the passage port 33.

Since both the first opening 31 and the second opening 32 at this time are in a closed state, no air flow is generated through the first opening 31 and the second opening 32.

FIG. 59 illustrates the operation of the rectifying system when the substrate W is located in the second processing chamber R2. FIG. 59 illustrates a state in which the substrate W is subjected to the second processing. In addition, in a case where the substrate W remains in the second processing chamber R2, for example, when the substrate W is gripped by the center robot CR, the rectifying system operates as follows.

In a case where the substrate W is located in the second processing chamber R2, the second valve V2 is in an open state, and the first valve V1 is in a closed state. At this time, the second fan 112 is in an operating state, and the first fan 111 is in a stopped state. Therefore, the first fan 111 in this case is not rotating.

In this case, as illustrated in FIG. 59, the air blown down by the second fan 112 passes through the second branch pipe 94 and reaches the intake and exhaust pipe 90.

On the other hand, since the first fan 111 at this time is stopped and the first valve V1 is in a closed state, no air flow is generated in the first processing chamber R1.

Since the passage port 33 at this time is in the closed state, no air flow is generated through the passage port 33.

The case where the substrate W is located in the second processing chamber R2 may be, for example, a case where the second processing is being performed. In this case, the first valve V1 and the second valve V2 are controlled so that the flow rate of the gas flowing through the second branch pipe 94 is larger than the flow rate of the gas flowing through the first branch pipe 93. In the present embodiment, the first valve V1 is in the fully closed state, but the present invention is not limited to this configuration, and the first valve V1 may be in the half-open state. That is, the air flow in the second processing chamber R2 during the second processing cannot be weakened from the guarantee of the processing quality, but the airflow in the first processing chamber R1 that is not processed is not related to the second processing at all. Therefore, the substrate processing apparatus 1 of the present embodiment is configured to stop or weaken the air flow in the first processing chamber R1 during the second processing. In a case where the air flow is generated in the first processing chamber R1 during the second processing, the first fan 111 may be operated or may not be operated.

FIG. 60 illustrates the air flow when the second opening 32 is in the open state. In a case where the second opening 32 is in the open state, in addition to the air flow described with reference to FIG. 59, an air flow from the second opening 32 toward the second exhaust opening 92 is also generated. A case where the second opening 32 is in the open state is a case where the second shutter S2 is in the open state and the substrate W is carried out by the center robot CR. When the substrate W is carried out through the second opening 32, the control unit 101 controls the second valve V2 so that gas flows from the outside toward the second processing chamber R2 through the second opening 32. This prevents the air in the second processing chamber R2 from leaking to the conveyance area (region B) when the substrate W is carried out of the second processing chamber R2.

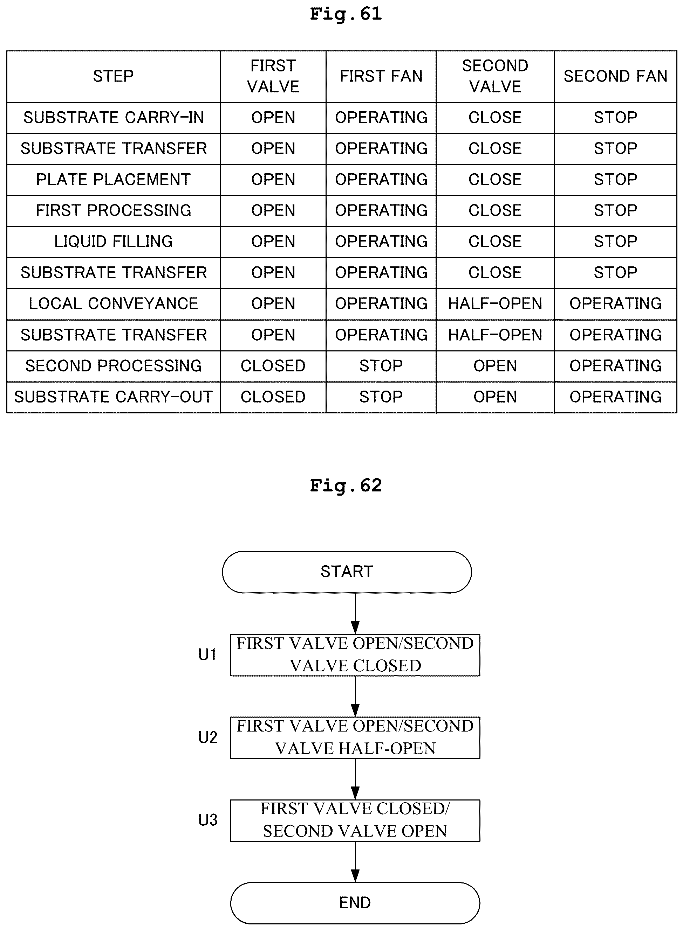

FIG. 61 illustrates a state of the rectifying system in each step of the substrate conveyance described in FIG. 17. In a case where the substrate W is carried into the first processing chamber R1, in a case where the substrate W is transferred from the center robot CR to the auxiliary robot 12, in a case where the auxiliary robot 12 places the substrate W on the plate 11, in a case where the first processing is performed, and in a case where the substrate is subjected to liquid filling, the first valve V1 is in an open state. Furthermore, in this case, the first fan 111 is in an operating state, the second valve V2 is in a closed state, and the second fan 112 is in a stopped state.

Furthermore, the first valve V1 during the local conveyance maintains the open state, but the second valve V2 is in the half-open state at this time. Similarly, the first fan 111 maintains the operating state during the local conveyance, but the second fan 112 enters the operating state. In this manner, the air flow described with reference to FIG. 58 is generated in the substrate processing chamber 10. When the auxiliary robot 12 delivers the liquid-filled substrate W to the vacuum chuck 21, the expansion and contraction arm 12B of the auxiliary robot 12 extends through the passage port 33. Therefore, the passage port 33 in this case is in an open state. That is, until the hand 12A of the auxiliary robot 12 returns to the first processing chamber R1 and the separation shutter S3 is in a closed state, the rectifying system maintains the same state as that at the time of the local conveyance.

In a case where the substrate W is subjected to the second processing in the second processing chamber R2, and in a case where the substrate W is conveyed from the second processing chamber R2 by the center robot CR, the second valve V2 is in an open state. Furthermore, in this case, the first fan 111 is in the stopped state, the first valve V1 is in the closed state, and the second fan 112 is in the operating state. As described above, the rectifying system operates to appropriately control the air flow in the substrate processing chamber in accordance with the conveyance stage of the substrate W.

### <19. Exhaust Method of Present Embodiment>

FIG. 62 is a flowchart illustrating the exhaust method of the present embodiment. Hereinafter, the exhaust method of the present embodiment will be described with reference to the drawing.

Step U1: When the substrate processing is executed in the first processing chamber R1, the exhaust flow rate of the first processing chamber R1 is made larger than the exhaust flow rate of the second processing chamber R2. This step corresponds to a first exhaust process of the present invention.

Step U2: When the substrate W is conveyed from the first processing chamber R1 to the second processing chamber R2, the exhaust amounts of the first processing chamber R1 and the second processing chamber R2 are adjusted so as to generate an air flow from the second processing chamber R2 toward the first processing chamber R1. This step corresponds to a third exhaust process of the present invention.

Step U3: When the substrate processing is executed in the second processing chamber R2, the exhaust flow rate of the second processing chamber R2 is made larger than the exhaust flow rate of the first processing chamber R1. This step corresponds to a second exhaust process of the present invention.

### <20. Effects of Present Invention>

The substrate processing apparatus 1 of the present invention includes: the first processing unit that performs the first processing on the substrate W; the second processing unit that is provided adjacent to the first processing unit in the horizontal direction and performs the second processing different from the first processing on the substrate W; the partition wall 34 that is provided between the first processing unit and the second processing unit and includes the passage port 33 that allows the substrate W to pass through; and the auxiliary robot 12 that conveys the substrate W between the first processing unit and the second processing unit via the passage port 33, and the auxiliary robot 12 is provided at a position separated from the virtual straight line V connecting the first processing unit and the second processing unit. With this configuration, since the first processing unit, the auxiliary robot 12, and the second processing unit can be arranged in a zigzag manner, the distance between the first processing unit and the second processing unit can be shortened as compared with the conventional configuration. Therefore, according to the present invention, the substrate processing apparatus 1 having a small footprint can be provided.

The auxiliary robot 12 of the substrate processing apparatus 1 described above is provided on the side opposite to the center robot CR across the virtual straight line V connecting the first processing unit and the second processing unit. With this configuration, the auxiliary robot 12 does not hinder the substrate conveyance of the center robot CR.

In the substrate processing apparatus 1 described above, the distance between the first processing unit and the robot base 12C is shorter than the distance between the second processing unit and the robot base 12C. With this configuration, the auxiliary robot 12 can be provided close to the first processing unit. With this configuration, the second processing unit that is located downstream of the substrate processing and performs finishing in the substrate processing, and the auxiliary robot 12 that causes generation of particles can be separated as much as possible.

The hand 12A in the auxiliary robot 12 of the substrate processing apparatus 1 described above is positioned above the substrate W when holding the substrate W. With this configuration, since the configuration of the processing unit can be diversified, it is possible to provide the substrate processing apparatus 1 capable of coping with various substrate processing.

The expansion and contraction arm 12B of the substrate processing apparatus 1 described above is extendable and contractible. Therefore, the substrate conveyance arm can reliably adjust the arm length.

The control unit of the substrate processing apparatus 1 described above controls the motor 15 and the expansion and contraction arm 12B to linearly move the substrate W from the first processing unit to the second processing unit. With such a configuration, since the conveyance distance of the substrate W becomes the shortest, the substrate conveyance becomes fast.

### <21. Modifications>

The present invention is not limited to the above-described configuration, and modifications can be made as follows.

### <Modification 1>

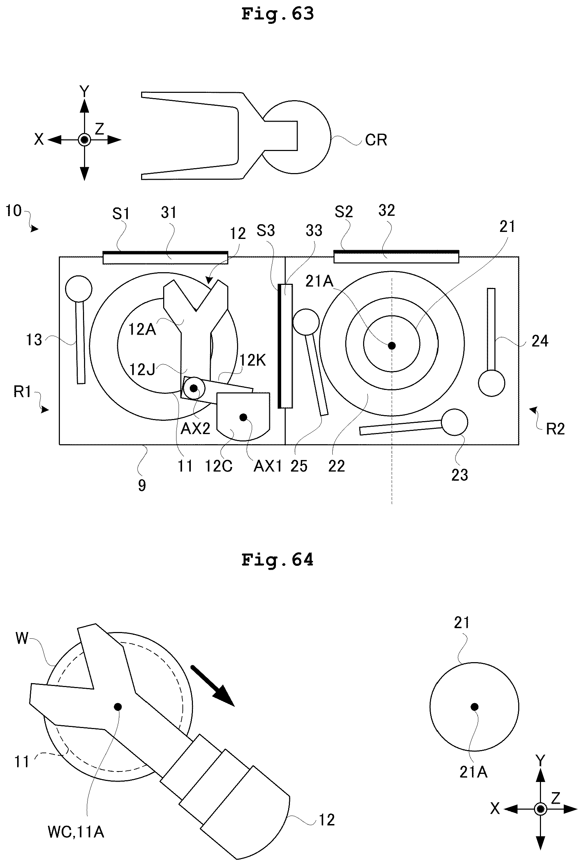

In the embodiment described above, the auxiliary robot 12 includes the expansion and contraction arm 12B, but the present invention is not limited to this configuration. As illustrated in FIG. 63, the substrate processing apparatus 1 of the present invention may include an auxiliary robot 12 including an articulated arm. The articulated arm of the present modification is provided with a base member 12K rotatable about a reference axis AX1 with respect to the robot base 12C, and a joint 12J coupling the base member 12K and the hand 12A. The joint 12J is provided with a rotation axis AX2 extending in the vertical direction Z, and the hand 12A can rotate about the rotation axis AX2 with respect to the base member 12K. The substrate conveyance arm of the substrate processing apparatus described above includes the plurality of joints. Therefore, the substrate conveyance arm can reliably adjust the arm length. In addition, specific examples of the expansion and contraction arm 12B include a mechanism using an air cylinder and a mechanism using a crank.

### <Modification 2>

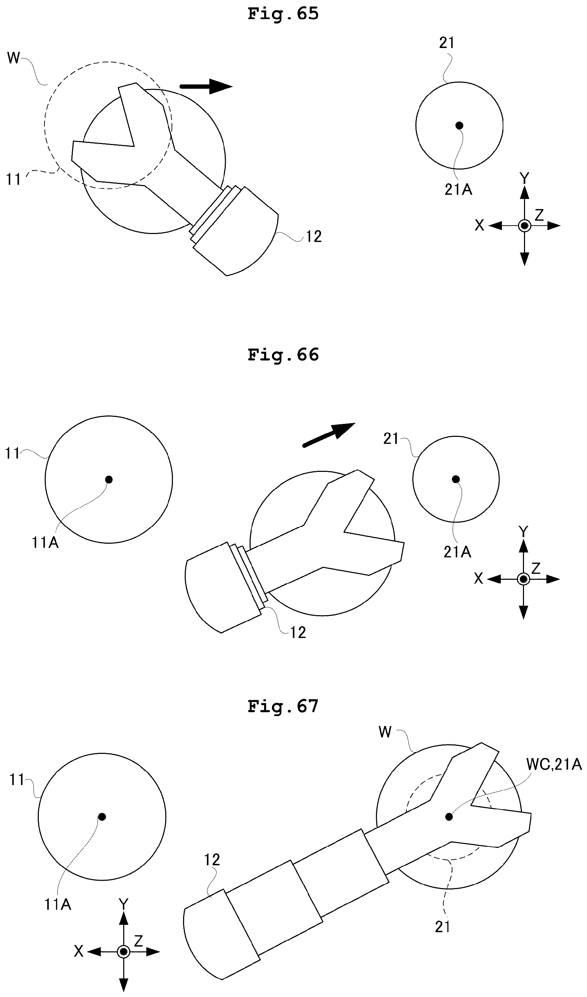

In the embodiment described above, the auxiliary robot 12 is configured to linearly move the substrate W, but the present invention is not limited to this configuration. The substrate processing apparatus 1 of the present invention can be configured to convey the substrate W by the operation illustrated in FIGS. 64 to 67. The control unit 101 of the present modification controls the expansion and contraction arm 12B to bring the substrate W acquired by the plate 11 close to the robot base 12C (See FIGS. 64 and 65). The arm length of the expansion and contraction arm 12B at this time is the shortest. Thereafter, the control unit 101 controls the motor 15 to turn the substrate W with reference to the robot base 12C (See FIGS. 65 and 66). Then, the control unit 101 controls the expansion and contraction arm 12B to displace the substrate W away from the robot base 12C and convey the substrate W to the vacuum chuck 21 (See FIGS. 66 and 67). With this configuration, since a turning radius when the substrate W is turned can be minimized, it is possible to reliably convey the liquid-filled substrate W in particular.

## Claims

1. A substrate processing apparatus including a substrate processing chamber (10) configured to process a substrate in a horizontal attitude, the substrate processing apparatus comprising
a center robot (CR) configured to transfer the substrate to and from the substrate processing chamber (10),
wherein
the substrate processing chamber (10) includes:
a first processing unit (11) configured to perform first processing on the substrate;
a second processing unit (21) provided adjacent to the first processing unit (11) in a horizontal direction and configured to perform second processing different from the first processing on the substrate;
a partition wall (34) provided between the first processing unit (11) and the second processing unit (21) and including a passage port configured to allow the substrate to pass through; and
an auxiliary robot (12) configured to convey the substrate between the first processing unit (11) and the second processing unit (21) via the passage port,
the auxiliary robot (12) includes:
a robot base (12C) provided adjacent to the partition wall (34);
a substrate conveyance arm (12B) configured to be movably supported by the robot base (12C);
a hand (12A) configured to be supported by the substrate conveyance arm (12B) and hold the substrate;
an arm turning mechanism (15) configured to turn the substrate conveyance arm (12B) with reference to the robot base (12C);
an arm length adjustment mechanism (12B) configured to change a turning radius of the hand (12A) by changing an arm length of the substrate conveyance arm (12B); and
a control unit (101) configured to control the arm turning mechanism (15) and the arm length adjustment mechanism (12B), and
the auxiliary robot (12) is provided at a position separated from a virtual straight line connecting the first processing unit (11) and the second processing unit (21).

2. The substrate processing apparatus according to claim 1, wherein the auxiliary robot (12) is provided on a side opposite to the center robot (CR) across the virtual straight line connecting the first processing unit (11) and the second processing unit (21).

3. The substrate processing apparatus according to claim 1, wherein a distance between the first processing unit (11) and the robot base (12C) is shorter than a distance between the second processing unit (21) and the robot base (12C).

4. The substrate processing apparatus according to claim 1, wherein the hand (12A) in the auxiliary robot (12) is located above the substrate when holding the substrate.

5. The substrate processing apparatus according to claim 1, wherein the substrate conveyance arm (12B) is extendable and contractible.

6. The substrate processing apparatus according to claim 1, wherein the substrate conveyance arm (12B) includes a plurality of joints.

7. The substrate processing apparatus according to claim 1, wherein the control unit (101) controls the arm turning mechanism (15) and the arm length adjustment mechanism (12B) to linearly move the substrate from the first processing unit (11) to the second processing unit (21).

8. The substrate processing apparatus according to claim 1, wherein
the control unit (101)
controls the arm length adjustment mechanism (12B) to bring the substrate acquired by the first processing unit (11) close to the robot base (12C),
controls the arm turning mechanism (15) to turn the substrate with reference to the robot base (12C), and
controls the arm length adjustment mechanism (12B) to displace the substrate away from the robot base (12C) and convey the substrate to the second processing unit (21).
